# EUROPEAN PATENT SPECIFICATION

(11) **EP 0 752 721 B1**
(45) Date of publication and mention of the grant of the patent: **29.04.2009**
(21) Application number: 96304829.3
(22) Date of filing: 28.06.1996
(51) Int. Cl.: H01L 27/115, H01L 21/8247, G11C 16/04

(54) **Nonvolatile semiconductor memory and driving method and fabrication method of the same**
Nichtflüchtiger Halbleiterspeicher und Verfahren zur Steuerung und Verfahren zu seiner Herstellung
Mémoire semi-conductrice non-volatile et méthode de commande et procédé de fabrication

(30) Priority: 29.06.1995 JP 16372795; 13.07.1995 JP 17728695; 25.06.1996 JP 16434396
(43) Date of publication of application: 08.01.1997
(73) Proprietor: Sharp Kabushiki Kaisha, Osaka-shi, Osaka 545-8522 (JP)
(72) Inventor: Yamauchi, Yoshimitsu, Nabari-shi, Mie-ken (JP)
(74) Representative: Brown, Kenneth Richard

(56) References cited:
- EP-A- 0 364 769
- EP-A- 0 419 663
- DE-A- 3 844 115
- US-A- 5 283 758
- US-A- 5 379 254
- IEEE TRANSACTIONS ON ELECTRON DEVICES, vol. 37, no. 4, 1 April 1990, pages 1046-1051, XP000125218 KUNIYOSHI YOSHIKAWA ET AL: "AN ASYMMETRICAL LIGHTLY DOPED SOURCE CELL FOR VIRTUAL GROUND HIGH-DENSITY EPROM'S"
- DIGEST OF TECHNICAL PAPERS OF THE SYMPOSIUM ON VLSI TECHNOLOGY, KYOTO, MAY 17 - 19, 1993, no. -, 17 May 1993, INSTITUTE OF ELECTRICAL AND ELECTRONICS ENGINEERS, page 57/58 XP000462904 OHI M ET AL: "AN ASYMMETRICAL OFFSET SOURCE/DRAIN STRUCTURE FOR VIRTUAL GROUND ARRAY FLASH MEMORY WITH DINOR OPERATION"

## Description

### BACKGROUND OF THE INVENTION

### 1. Field of the Invention:

The present invention relates to a nonvolatile semiconductor memory using a Fowler-Nordheim (FN) tunnel current for writing and erasing, and a driving method and fabrication method for such a nonvolatile semiconductor memory. More specifically, the present invention relates to a flash memory, and a driving method and fabrication method for the flash memory.

### 2. Description of the Related Art:

Conventional general flash memories are classified into the type using hot electron injection for writing and the type using an FN tunnel current for writing.

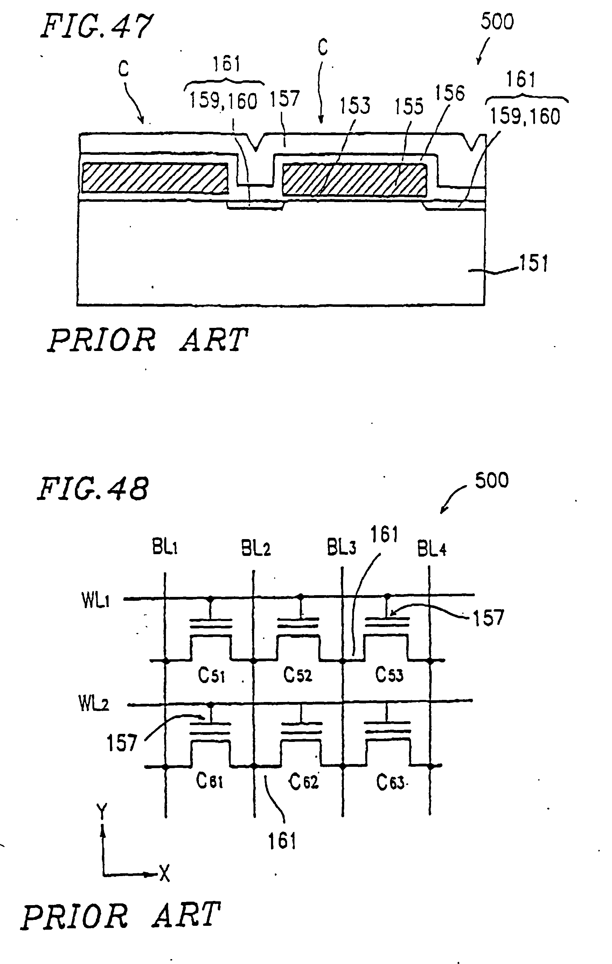

Figure 47 is a sectional view of memory cells of a conventional flash memory 500 of the type using hot electron injection. Figure 48 is an equivalent circuit of a memory cell array of the flash memory 500.

Referring to Figure 47, the flash memory 500 includes a semiconductor substrate 151, a tunnel insulating film 153 formed on the semiconductor substrate 151, and floating gates 155 formed on the tunnel insulating film 153. An insulating film 156 made of ONO(SiO₂/SiN/SiO₂) and the like is formed covering the floating gates 155. Control gates 157 are formed on the insulating film 156. As shown in Figure 48, memory cells (memory cells C₅₁ to C₅₃ and C₆₁ to C₆₃ are shown in Figure 48) are arranged in a matrix. The control gates 157 of the memory cells lined in an X direction shown in Figure 47 are electrically connected to one another, forming a word line WL (word lines WL₁ and WL₂ are shown in Figure 48).

As shown in Figure 47, an impurity diffusion layer (a source/drain diffusion layer) 161 is formed between every two memory cells adjacent in the X direction, and shared by the two memory cells as a source diffusion layer 159 for one memory cell and a drain diffusion layer 160 for the other memory cell. Such source/drain diffusion layers are formed in a self-aligning manner by ion implantation using a film as a mask during the fabrication process. Upon completion of the fabrication process, the film will become the floating gates 155 formed in a stripe shape.

As shown in Figure 48, bit lines BL (bit lines BL₁ to BL₄ are shown in Figure 48) extend in the Y direction, electrically connecting the diffusion layers 161 lined in the Y direction with one another. Each bit line serves as a source wiring or a drain wiring depending on the selected memory cell. Such a driving method where each bit line is not fixed as the source wiring or the drain wiring, but where the source wiring (ground line) and the drain wiring are appropriately switched is called a virtual ground method.

In the virtual ground method, since the impurity diffusion layer 161 is used both as the source diffusion layer 159 for one memory cell and the drain diffusion layer 160 for a memory cell adjacent in the X direction as described above, no isolation region is required between the source diffusion layer 159 for one memory cell and the drain diffusion layer 160 for the adjacent memory cell in the X direction. Furthermore, since the bit lines BL are formed by connecting the impurity diffusion layers 161 lined in the Y direction via diffusion wirings, no contact regions are required for the connection of the bit lines BL with the memory calls. This makes it possible to realize high integration of memories.

Japanese Laid-Open Patent Publication No. 2-231772, for example, discloses the configuration shown in Figure 51, where two memory cells adjacent in the X direction are paired, sharing a source line SL but having individual bit lines BL. This configuration allows for parallel reading and parallel writing of data.

Referring to Figure 48, the write operation of a flash memory 500 is conducted in the following manner. Assume that the memory cell C₅₂ is selected as a memory cell in which data is to be written (hereinafter, such a selected memory cell is referred to as a selected cell). First, a high voltage is applied to the word line WL₁ connected with the selected cell C₅₂. Simultaneously, a predetermined voltage is applied to one of the bit lines connected with the selected cell C₅₂, (e.g., the bit line BL₃) to define the drain side, while a ground voltage (0 V) is applied to the other bit line (e.g., the bit line BL₂) to define the source side. As a result, hot electrons generated in a channel region of the selected cell C₅₂ are injected into the floating gate 155, allowing data to be written in the memory cell C₅₂. At this time, for the other memory cells where no data is written (hereinafter, such memory cells are referred to as non-selected cells), certain voltages are applied to two bit lines connected with any one of the non-selected cells so that the two bit lines have the same potential. For example, for the non-selected cell C₅₃ voltages are applied to the bit lines BL₃ and BL₄ so that the potentials of these bit lines are the same.

The erase operation of the flash memory 500 is conducted in the following manner. A negative voltage is applied to the word lines WL, and simultaneously, a predetermined positive voltage is applied to all the bit lines BL (or all bit lines in a block when the memory cell array is divided into blocks). This causes an FN tunnel current to flow, drawing out charges accumulated in the floating gates 155 and thus erasing data stored in all the memory cells (or all memory cells in the block) at one time.

The read operation of the flash memory 500 is conducted in the following manner. A predetermined voltage is applied to a word line WL connected with a selected cell for reading. Simultaneously, a predetermined voltage is applied to one of two bit lines connected with the selected cell, while a ground voltage (0 V) is applied to the other bit line. The amount of current flowing between the two bit lines is different depending on the amount of charge (i.e., data) stored in the floating gate 155. The data is thus read by detecting the amount of current. At this time, voltages are applied to two bit lines connected with a non-selected cell where no reading is conducted so that the potential of the two bit lines is the same as in the write operation.

The write operation using the channel hot electron injection as described above has the following drawbacks. The efficiency of electron injection (write efficiency) is generally poor. Since the write current is large (about 1 mA), power consumption at writing is large. A high-voltage power source (or a booster) is required to supply the comparatively large write current, which prevents the flash memory 500 from lowering the driving voltage and using a single power source.

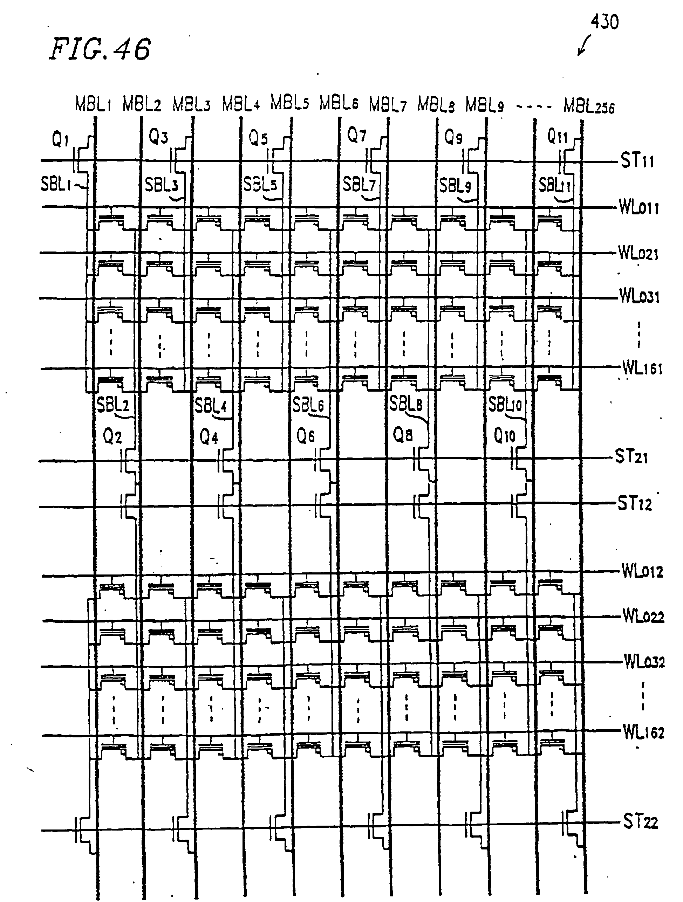

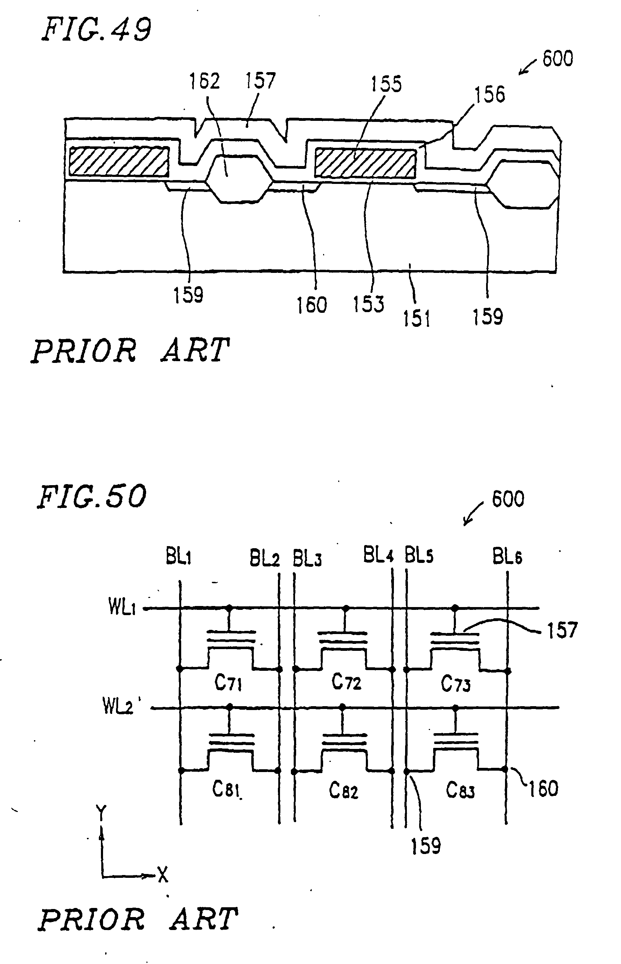

In contrast, a flash memory using an FN tunnel current for writing requires a write current of only about several tens of nanoamps (nAs). Therefore, this type of flash memory can use a single power source. Figure 49 is a sectional view of memory cells of a conventional flash memory 600 of the type using an FN tunnel current for writing. Figure 50 is an equivalent circuit of a memory cell array of flash memory 600. Similar components to those of flash memory 500 shown in Figures 46 and 47 are denoted by the same reference numerals.

Referring to Figure 49, the flash memory 600 includes a semiconductor substrate 151, a tunnel insulating film 153 formed of a uniform oxide film on the semiconductor substrate 151, and floating gates 155 formed on the tunnel insulating film 153. A source diffusion layer 159 and a drain diffusion layer 160 are formed on both ends of each of the floating gates 155. An element isolation film 162 is formed between every two adjacent memory cells, isolating the source diffusion layer 159 of one memory cell from the drain diffusion layer 160 of the other memory cell. An insulating film 156 made of ONO (SiO₂/SiN/SiO₂) is formed covering the floating gates 155. Control gates 157 are formed on the insulating film 156.

Referring to Figure 50, memory cells (memory cells C₇₁ to C₇₃ and C₈₁ to C₈₃ are shown in Figure 50) are arranged in a matrix. The control gates 157 of the memory cells lined in the x direction shown in Figure 50 are electrically connected with one another, forming a word line WL (word lines WL₁ and WL₂ are shown in Figure 50). Bit lines BL (bit lines BL₁ to BL₆ are shown in Figure 50) extend in the Y direction, electrically connecting the corresponding source diffusion layers 159 or the drain diffusion layers 160 with one another. The function of each bit line BL is fixed as the source line or the drain line.

The write operation of the flash memory 600 is conducted in the following manner. A negative voltage or 0 V is applied to the word line WL connected with a selected cell, while a positive voltage is applied to the drain diffusion layer 160 of the connected cell so that electrons are drawn out of the floating gate 155. The erase operation is conducted in the following manner. A positive high voltage is applied to one word line WL, while 0 V is applied to the source diffusion layers 159 and the drain diffusion layers 160 so that electrons are injected into the floating gates of all the memory cells connected with the word line WL.

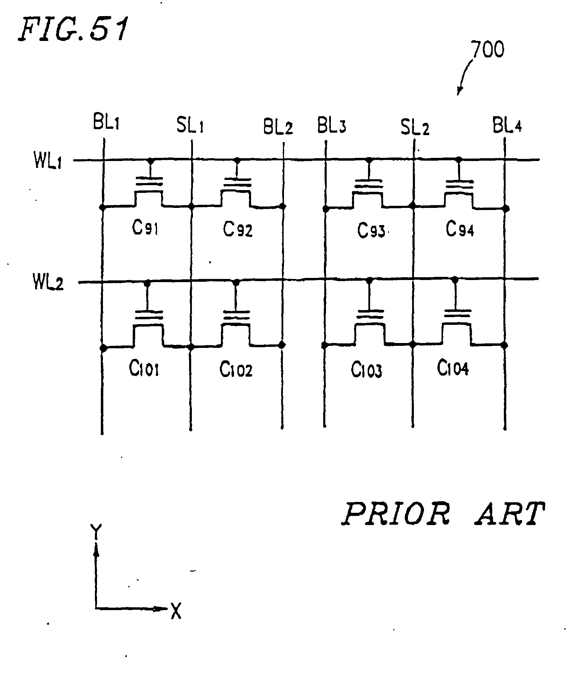

Figure 51 shows another example of the flash memory 700 using an FN tunnel current. In the memory cell 600 of Figure 49, the drain diffusion layer and the source diffusion layer cell of the adjacent memory calls are isolated from each other. In the flash memory 700 of Figure 51, the drain diffusion layers of respective memory cells are separated from one another and these individual drain diffusion layers lined in the Y direction are connected with one another to form a bit line. Simultaneously, each pair of memory cells adjacent in the X direction share the source diffusion layer to form a source line extending in the Y direction.

However, the conventional flash memory of the type using an FN tunnel current has the following drawbacks. As described above, in the conventional memory using an FN tunnel current for writing, a tunnel current generated by the electric field applied to the tunnel insulating film 153 is used. Accordingly, if in the memory cells shown in Figure 49, each pair of memory cells adjacent in the X direction share the diffusion layer as shown in Figure 48, data will be written in a non-selected memory cell which shares the drain diffusion layer with a selected memory cell in data is to be written and is connected with the same word line as the selected memory cell. Accordingly, it is necessary to form the element isolation film 162 as shown in Figure 49 and isolate at least the drain diffusion layers 160 of the adjacent memory cells in the X direction from each other as shown in Figures 50 and 51. Thus, the conventional flash memory of the type using an FN tunnel current for writing cannot employ the virtual ground method. This prevents the flash memory of this type from being made smaller.

As shown in Figure 49, the tunnel insulating film 153 is comparatively thin. Accordingly, when a comparatively high voltage is applied to the drain diffusion layer 160 at writing, a current 10⁶ times the write current may sometimes flow from the end of the drain diffusion layer 160 to the substrate 151 due to the interband tunnel phenomenon.

As the tunnel insulating film 153 becomes thin-ner, the capacitance between the floating gate and the substrate is larger. This makes it difficult to increase the capacitance coupling ratio of the control gate. Also, as the tunnel insulating film 153 becomes thinner, the disturb margin against a high voltage to be applied to the control gate electrode at writing becomes smaller.

### SUMMARY OF THE INVENTION

The nonvolatile semiconductor memory of this invention includes: a semiconductor substrate; a plurality of memory cells (C) formed in a matrix on the semiconductor substrate, each of the memory cells including a first insulating film formed on the semiconductor substrate, a floating gate formed on the first insulating film, and a control gate formed on the floating gate via a second insulating film sandwiched therebetween, a source diffusion region, and a drain diffusion region; a diffusion layer formed in a portion of the semiconductor substrate located between two of the memory cells (C) adjacent in a first direction, the diffusion layer including the drain diffusion region for one of the two memory cells (C) and the source diffusion region for the other memory cell; a word line formed by connecting the control gates of the memory cells (C) lined in the first direction; and a bit line formed by connecting the diffusion layers lined in a second direction substantially perpendicular to the first direction, wherein the memory cells have a structure in which a tunnel current flows between the drain diffusion region and the floating gate of one of the two adjacent memory cells via the first insulating film when a predetermined voltage is applied to the diffusion layer and no tunnel current flows between the diffusion layer and the floating gate of the other memory cell, wherein the impurity dose amount of the source diffusion layer is set in proportion with the drain diffusion layer, such that the impurity dose amount of the source diffusion layer is less than the impurity dose amount of the drain diffusion layer by a factor of 100 times or more.

In one embodiment of the invention, the source diffusion region and the drain diffusion region of each of the memory cells have impurity densities different from each other.

In another embodiment of the invention, the drain diffusion region has a double-layered diffusion layer structure where the impurity density is lower in an outer layer.

According to another aspect of the invention, a method for fabricating a nonvolatile semiconductor memory according to claim 8 is provided.

A method for erasing a nonvolatile semiconductor memory is provided. The memory includes: a plurality of memory cells formed in a matrix on a semiconductor substrate and divided into a plurality of blocks; a word line formed by connecting control gates of the memory cells lined in a first direction; a first bit line formed by connecting diffusion layers formed between the memory cells adjacent in the first direction in a second direction perpendicular to the first direction; a second bit line provided to correspond to a predetermined number of the first bit lines; and a selective transistor provided to correspond to each of the first bit lines for connecting the first bit line to the corresponding second bit line. The method includes the steps of: electrically connecting the first bit lines in a selected block to the corresponding second bit lines, while putting the first bit lines in blocks other than the selected block in a floating state by controlling the selective transistors; applying a predetermined negative voltage to the first bit lines and the semiconductor substrate; applying a predetermined positive voltage to the word lines in the selected block, while applying a ground voltage to the word lines in the blocks other than the selected block; and consequently erasing data in the memory cells in the selected block using a tunnel current.

Alternatively, a method for reading data stored in a nonvolatile semiconductor memory is provided. The memory includes: a plurality of memory cells formed in a matrix on a semiconductor substrate and divided into a plurality of blocks; a word line formed by connecting control gates of the memory cells lined in a first direction; a first bit line formed by connecting diffusion layers formed between the memory cells adjacent in the first direction in a second direction perpendicular to the first direction; a second bit line provided to correspond to a predetermined number of the first bit lines; and a selective transistor provided to correspond to each of the first bit lines for connecting the first bit line to the corresponding second bit line selectively. The method includes the steps of: applying a predetermined voltage to the word line connected with the memory cell from which data is to be read; applying a predetermined voltage to one of the first bit lines connected with a source diffusion layer of the memory cell from which data is to be read, and applying the same predetermined voltage to the other first bit lines existing in parallel with the one of the first bit lines via the one of the first bit lines under a floating state.

Thus, according to the present invention, an asymmetric memory cell where the coupling capacitance of the floating gate is asymmetric between the source diffusion region side and the drain diffusion region side at writing is used. Accordingly, when voltages are applied to a word line and bit lines (drain diffusion layers) connected with a selected memory cell (selected cell), no data is written in a non-selected cell of which the source diffusion region is connected with the selected bit line. Such an asymmetric memory cell can be realized by having the impurity density of the drain diffusion layer higher than that of the source diffusion layer. Since the floating gate is capacitively coupled with the high-density drain diffusion layer, a tunnel current easily flows between the floating gate and the drain diffusion layer via the tunnel insulating film. In contrast, the impurity density of the source diffusion layer capacitively coupled with the floating gate is low even if the same voltage as that applied to the drain diffusion layer is applied to the source diffusion layer. The surface of this low-density source diffusion layer is thus depleted, lowering the electric field applied to the tunnel insulating film and thus preventing the tunnel phenomenon from occurring. Thus, in the non-selected cell sharing the bit line with the selected cell, no tunnel current flows since the floating gate thereof is capacitively coupled with the low-density source diffusion layer of the shared bit line, preventing data from being mistakenly written in the non-selected cell.

Thus, the invention described herein makes possible the advantages of (1) providing a nonvolatile semiconductor memory using an FN tunnel current for writing and erasing and employing the virtual ground method for driving a memory cell array thereof, (2) providing a driving method of such a nonvolatile semiconductor memory, (3) providing a fabrication method of such a nonvolatile semiconductor memory, (4) providing a nonvolatile semiconductor memory with high write efficiency and reliability where a current flowing into a semiconductor substrate at writing is reduced, (5) providing a driving method of such a nonvolatile semiconductor memory, and (6) providing a fabrication method of such a nonvolatile semiconductor memory.

These and other advantages of the present invention will become apparent to those skilled in the art upon reading and understanding the following detailed description with reference to the accompanying figures.

### BRIEF DESCRIPTION OF THE DRAWINGS

Figure 1 is a plan view of a portion of a memory cell array of a nonvolatile semiconductor memory of Example 1 according to the present invention.
Figures 2A and 2B are sectional views of the memory cell array shown in Figure 1 taken along lines A-A and B-B of Figure 1, respectively.
Figure 3 is an equivalent circuit diagram of the memory cell array of the nonvolatile semiconductor memory of Example 1.
Figure 4 shows the relationship between the impurity dose amount of a source diffusion layer and the influence of the write operation to a non-selected cell.
Figure 5 is a plan view illustrating a portion of a memory cell array of a nonvolatile semiconductor memory of Example 1 according to the present invention.
Figure 6 is a sectional view illustrating a step of a fabrication method of memory cells of the nonvolatile semiconductor memory of Example 2 according to the present invention.
Figure 7 is a sectional view illustrating a step of the fabrication method of the memory cells of the nonvolatile semiconductor memory of Example 2 according to the present invention.
Figure 8 is a sectional view illustrating a step of the fabrication method of the memory cells of the nonvolatile semiconductor memory of Example 2 according to the present invention.
Figure 9 is a sectional view illustrating a step of the fabrication method of the memory cells of the nonvolatile semiconductor memory of Example 2 according to the present invention.
Figure 10 is a sectional view illustrating a step of the fabrication method of the memory cells of the nonvolatile semiconductor memory of Example 2 according to the present invention.
Figures 11A, 11B, 11C, and llD are sectional views illustrating steps of an alternative fabrication method of memory cells of the nonvolatile semiconductor memory of Example 2 according to the present invention.
Figures 12A and 12B are sectional views illustrating a tilt ion injection process of another alternative fabrication method of memory cells of the nonvolatile semiconductor memory of Example 2 according to the present invention.
Figure 13A is a plan view of a portion of a memory cell array of an alternative nonvolatile semiconductor memory according to the present invention, where element isolation is conducted by a p-n joint, and Figure 13B is a sectional view of the memory cells shown in Figure 13A taken along line D-D of Figure 13A.
Figure 14 is a plan view of a portion of a memory cell array of a nonvolatile semiconductor memory of Example 3.
Figures 15A and 15B are sectional views of the memory cell array shown in Figure 14 taken along lines A-A and B-B of Figure 14, respectively.
Figure 16 is an equivalent circuit diagram of the memory cell array of the nonvolatile semiconductor memory of Example 3.
Figure 17 shows the relationship between the thickness of a gate insulating film and the write efficiency (leak current/tunnel current).
Figure 18 is a plan view of a portion of a memory cell array of an alternative nonvolatile semiconductor memory.
Figure 19 is a sectional view illustrating a step of a fabrication method of memory cells of a nonvolatile semiconductor memory of Example 4.
Figure 20 is a sectional view illustrating a step of the fabrication method of the memory cells of the nonvolatile semiconductor memory of Example 4.
Figure 21 is a sectional view illustrating a step of the fabrication method of the memory cells of the nonvolatile semiconductor memory of Example 4.
Figure 22 is a sectional view illustrating a step of the fabrication method of the memory cells of the nonvolatile semiconductor memory of Example 4.
Figure 23 is a sectional view illustrating a step of the fabrication method of the memory cells of the nonvolatile semiconductor memory of Example 4.
Figure 24 is a sectional view illustrating a step of an alternative fabrication method of the memory cells of the nonvolatile semiconductor memory of Example 4.
Figure 25 is a sectional view illustrating a step of the alternative fabrication method of the memory cells of the nonvolatile semiconductor memory of Example 4.
Figure 26 is a sectional view illustrating a step of the alternative fabrication method of the memory cells of the nonvolatile semiconductor memory of Example 4.
Figure 27 is a sectional view illustrating a step of the alternative fabrication method of the memory cells of the nonvolatile semiconductor memory of Example 4.
Figure 28 is a sectional view illustrating a step of the alternative fabrication method of the memory cells of the nonvolatile semiconductor memory of Example 4.
Figure 29A is a plan view of a portion of a memory cell array of an alternative nonvolatile semiconductor memory according to the present invention, where element isolation is conducted by a p-n joint, and Figure 29B is a sectional view of the memory cells shown in Figure 29A taken along line D-D of Figure 29A.
Figure 30 is a plan view of a portion of a memory cell array of a nonvolatile semiconductor memory of Example 5.
Figures 31A and 31B are sectional views of the memory cell array illustrated in Figure 30 taken along lines A-A and B-B of Figure 30, respectively.
Figure 32 is a sectional view illustrating a step of a fabrication method of memory cells of the nonvolatile semiconductor memory of Example 5.
Figure 33 is a sectional view illustrating a step of the fabrication method of the memory cells of the nonvolatile semiconductor memory of Example 5.
Figure 34 is a sectional view illustrating a step of the fabrication method of the memory cells of the nonvolatile semiconductor memory of Example 5.
Figure 35 is a sectional view illustrating a step of the fabrication method of the memory cells of the nonvolatile semiconductor memory of Example 5.
Figure 36 is a sectional view illustrating a step of the fabrication method of the memory cells of the nonvolatile semiconductor memory of Example 5.
Figure 37 is a sectional view illustrating a step of the fabrication method of the memory cells of the nonvolatile semiconductor memory of Example 5.
Figure 38 is a sectional view illustrating a step of the fabrication method of the memory cells of the nonvolatile semiconductor memory of Example 5.
Figure 39 is a plan view of a portion of a memory cell array of a nonvolatile semiconductor memory of Example 6.
Figure 40 shows a state of a memory cell in the read operation.
Figure 41 shows the relationship between the read current (channel current) and the leak current in the read operation.
Figure 42 is a timing chart schematically showing the applied voltages in the erase operation.
Figure 43 shows the relationship between the voltage application time to a control gate and the threshold voltage of a memory cell when a negative voltage is applied to a source/drain diffusion layer and a semiconductor substrate.
Figure 44 shows the relationship between the negative voltage applied to the semiconductor substrate and the life of the memory cell (reliability).
Figure 45 is a timing chart schematically showing the applied voltages in the write operation.
Figure 46 ia a plan view of an alternative example of the memory cell array of the nonvolatile semiconductor memory.
Figure 47 is a sectional view of a portion of a memory cell array of a conventional nonvolatile semiconductor memory of the type of using hot electron injection for writing.
Figure 48 is an equivalent circuit diagram of the memory cell array of the nonvolatile semiconductor memory illustrated in Figure 47.
Figure 49 is a sectional view of a portion of a memory cell array of a conventional nonvolatile semiconductor memory of the type of using an FN tunnel current for writing.
Figure 50 is an equivalent circuit diagram of the memory cell array of the nonvolatile semiconductor memory illustrated in Figure 49.
Figure 51 is an equivalent circuit diagram of a portion of a memory cell array of another conventional semiconductor memory of the type of using an FN tunnel current for writing.

### DESCRIPTION OF THE PREFERRED EMBODIMENTS

The present invention will be described by way of examples with reference to the accompanied drawings.

### (Example 1)

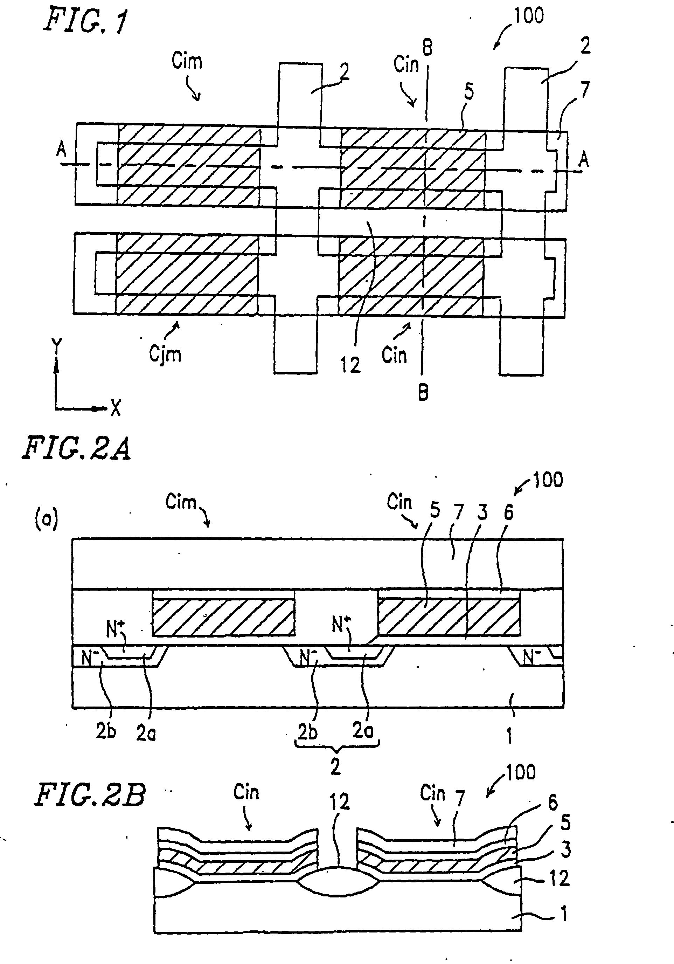

Figure 1 is a plan view of a portion of a memory cell array of a nonvolatile semiconductor memory 100 of Example 1 according to the present invention. Figures 2A and 2B are sectional views of the nonvolatile semiconductor memory 100 taken along lines A-A and B-B of Figure 1, respectively,

Referring to Figures 1, 2A, and 2B, the nonvolatile semiconductor memory 100 includes a plurality of memory cells C formed in a matrix on a semiconductor substrate 1. In Figure 1, the respective memory cells C are denoted by individual codes such as Cᵢₙ. Each of the memory cells C includes a tunnel insulating film 3 formed on the semiconductor substrate 1 and a floating gate 5 formed on the tunnel insulating film 3.

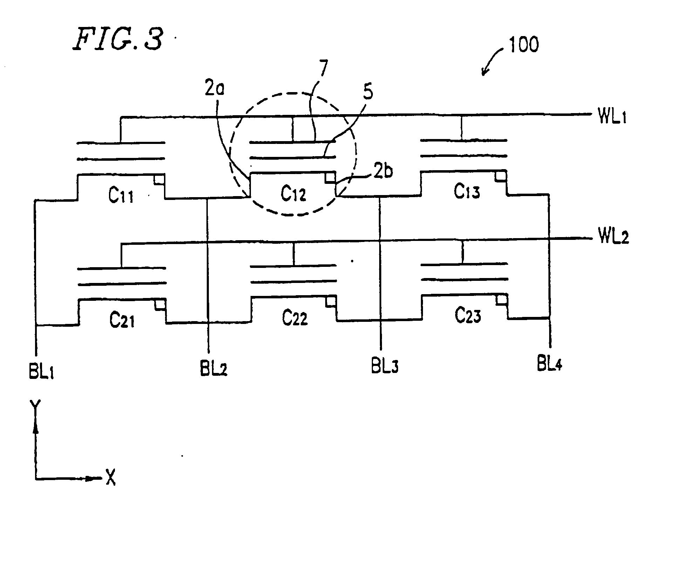

A control gate 7 is formed on the floating gate 5 via an insulating film 6 made of ONO and the like. Such control gates 7 extend in a channel direction of the memory cell C (an X direction shown in Figure 1), constituting a word line WL as shown in Figure 3 for connecting the memory cells C lined in the X direction.

As shown in Figures 1 and 2A, a diffusion layer 2 is formed between every two memory cells adjacent each other in the X direction (e.g., memory cells Cᵢₙ and cᵢₙ). The diffusion layer 2 includes a drain diffusion layer 2a for one of the two adjacent memory cells (e.g., the memory cell Cᵢₙ) and a source diffusion layer 2b for the other memory cell (e.g., the memory cell Cᵢₙ). The diffusion layer 2 is thus shared by the two adjacent memory cells. The impurity density of the drain diffusion layer 2a (N⁺) is made higher than that of the source diffusion layer 2b (N⁻). The diffusion layer 2 has a double-layered structure where the drain diffusion layer 2a is formed inside the diffusion region with a low impurity density constituting the source diffusion layer 2b.

In the memory cell C located between the two diffusion layers 2, the floating gate 5 is capacitively coupled with the drain diffusion layer 2a of one of the two diffusion layers 2 via the tunnel insulating film 3 (defining the drain side), while it is capacitively coupled with the source diffusion layer 2b of the other diffusion layer 2 via the tunnel insulating film 3 (defining the source side). The tunnel insulating film 3 may be composed of a silicon oxide film or a lamination of a silicon oxide film and a silicon nitride film.

In this example, the diffusion layers 2 lined in the Y direction are connected with one another via diffusion layer wirings, forming a so-called buried bit line. Alternatively, the diffusion layers 2 may be electrically connected with one another with metal wirings. In the latter case, a contact region is required for each diffusion layer 2. As shown in Figure 2B, a field oxide film (element isolation film) 12 is formed between two memory cells adjacent in the Y direction (e.g., the memory cells Cᵢₙ and Cⱼₙ) .

As shown in the equivalent circuit diagram of Figure 3, the nonvolatile semiconductor memory 100 employs the virtual ground method, where bit lines BL (bit lines BL₁ to BL₄ are shown in Figure 3) serve as source wirings or drain wirings depending on the selected cell.

The operation of the nonvolatile semiconductor memory 100 will now be described. Table 1 below shows the operation conditions when the memory cell C₁₂ shown in Figure 3 is selected, for example.

**TABLE 1**

| Operation mode | Word line voltage (V) | | Bit line voltage (V) | | | |
|---|---|---|---|---|---|---|
| | Selected | Non-selected | BL₁ | BL₂ | BL₃ | BL₄ |
| | WL₁ | WL₂ | | | | |
| Write | -8 | 0 | Float | 4 | Float | Float |
| Erase | 17 | 0 | 0 | 0 | 0 | 0 |
| Read | 3 | 0 | 0 | 0 | 1 | 1 |

In the write operation, a negative high voltage V_{H1} (e.g., -8 V) is applied to the word line WL₁ connected with the control gate 7 of the memory cell C₁₂, while 0 V is applied to the other word lines. A predetermined positive voltage V_{cc} (e.g., 4 V) is applied to the bit line BL₂ connected with the drain diffusion layer 2a for the memory cell C₁₂, while the other bit lines are put in a floating state. In the memory cell C₁₂ of the above state, a tunnel current flows from the drain diffusion layer 2a to the floating gate 5 via the tunnel insulating film 3 due to the electric field applied between the floating gate 5 and the drain diffusion layer 2a, allowing data to be written in the memory cell C₁₂.

The same write voltage is also applied to the control gate 7 of a non-selected cell which is connected with the selected word line WL and the source diffusion layer 2b of the bit line BL of which source is selected, for example, the non-selected cell C₁₁ which is connected with the word line WL₁ and the bit line BL₂. However, since the impurity density of the source diffusion layer 2b is low, no tunnel current flows between the source diffusion layer 2b and the floating gate 5 of the non-selected cell C₁₁. Accordingly, even though the diffusion layer 2 is shared with the selected cell, no data is written in the non-selected cell.

In the erase operation, first, 0 V is applied to all the bit lines BL. Then, a positive high voltage V_{H2} (e.g., 17 V) is applied to a desired word line WL. This allows electrons to be injected into the floating gates 5 of a plurality of memory cells simultaneously, and thus data are erased at one time. For example, when a high voltage V_{H2} is applied to the word line WL₁, date in the memory cells C₁₁, C₁₂, and C₁₃ are erased at one time. When a high voltage V_{H2} is applied to the word line WL₂, date in the memory cells C₂₁, C₂₂, and C₂₃ are erased at one time.

The data reading from the selected cell C₁₂ is conducted in a conventional manner. First, a predetermined voltage V_{cc} (e.g., 3·V) is applied to the word line WL₁. simultaneously, a predetermined voltage V_{L} (e.g., 1 V) is applied to the bit line BL₂, and 0 V is applied to the bit line BL₃. A current flows between these bit lines, and data is read by detecting a potential at the bit line BL₃.

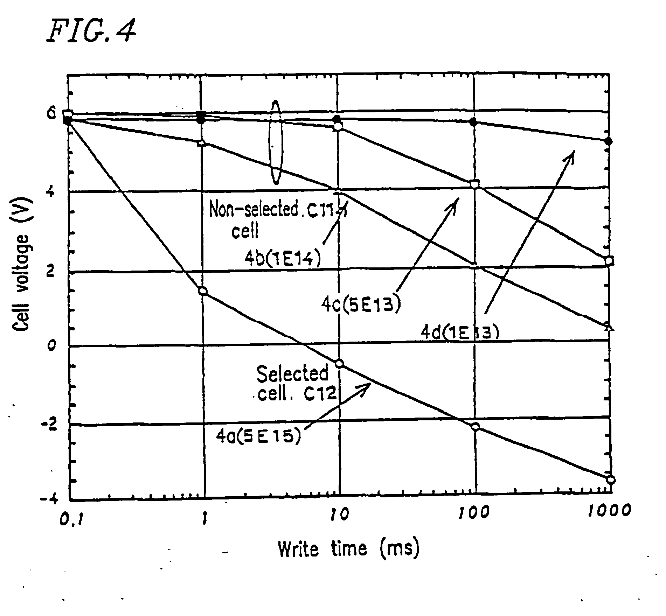

Now, the influence given to a non-selected cell (e.g., the memory cell C₁₁) by the write operation for a selected cell (e.g., the memory cell C₁₂) will be described. Figure 4 shows a change in the cell voltage (threshold) of the non-selected cell C₁₁ when the impurity dose amount of the source diffusion layer 2b is changed. A curve 4a represents the change in the threshold voltage when data is written in a memory cell of which drain diffusion layer 2a has a impurity dose amount of 5 x 10 ¹⁵/cm², while curves 4b to 4d represent changes in the threshold voltage when the same voltage as that applied to the drain diffusion layer in the write operation is applied to the source diffusion layer of memory cells of which source diffusion layer 2b has a impurity dose amount of 1 × 10¹⁴/cm², 5 × 10¹³/cm², and 1 × 10¹³/cm², respectively.

As is observed from the curve 4a, when a negative high voltage is applied to the drain diffusion layer of the selected cell C₁₂, electrons are drawn from the floating gate, lowering the threshold value. When this voltage application is retained for 10 ms or longer, the threshold voltage of the selected cell C₁₂, falls below 0 V. At this time, as shown in curves 4c and 4d, the threshold voltage of the non-selected cell C₁₁ of which source diffusion layer is in contact with the drain diffusion layer of the selected cell C₁₂ hardly changes when the impurity dose amount of the source diffusion layer 2b is 5 × 10¹³/cm² or less. The threshold voltage of the non-selected cell C₁₁ is 4 V even when a high voltage is applied to the selected cell C₁₂ for 100 ms. In the case where the impurity dose amount of the source diffusion layer 2b is 1 × 10¹³/cm² (curve 4d), the threshold voltage of the non-selected cell C₁₁ hardly changes when a high voltage is applied to the selected cell C₁₂ for 1000 ms. Thus, by appropriately setting the impurity dose amount of the source diffusion layer 2b, the non-selected cell adjacent to the selected cell is not influenced by the write operation for the selected cell even though the diffusion layer 2 is shared with the selected cell. This makes it possible to write data only in the selected cell.

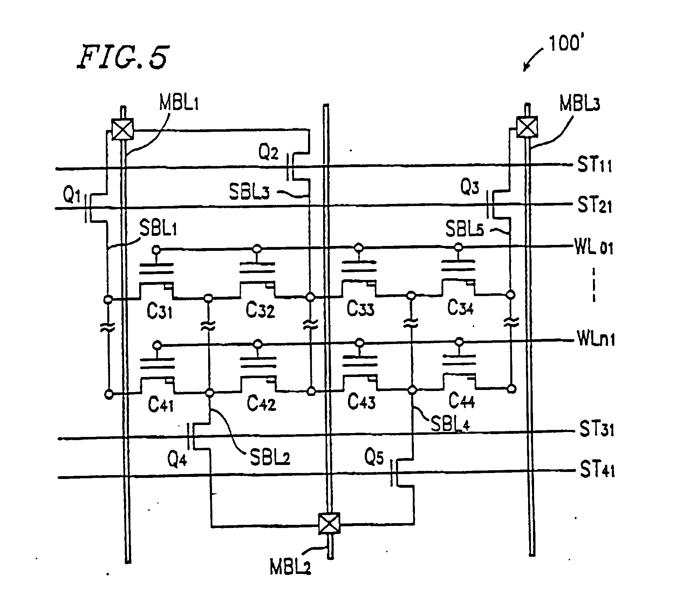

Figure 5 shows an example of an equivalent circuit of a nonvolatile semiconductor memory cell array 100' where, in order to reduce the wiring resistance of the bit line BL composed of the diffusion layers shown in Figure 3, a sub-bit line SBL is connected to a main bit line MBL made of metal via a selective transistor.

### (Example 2)

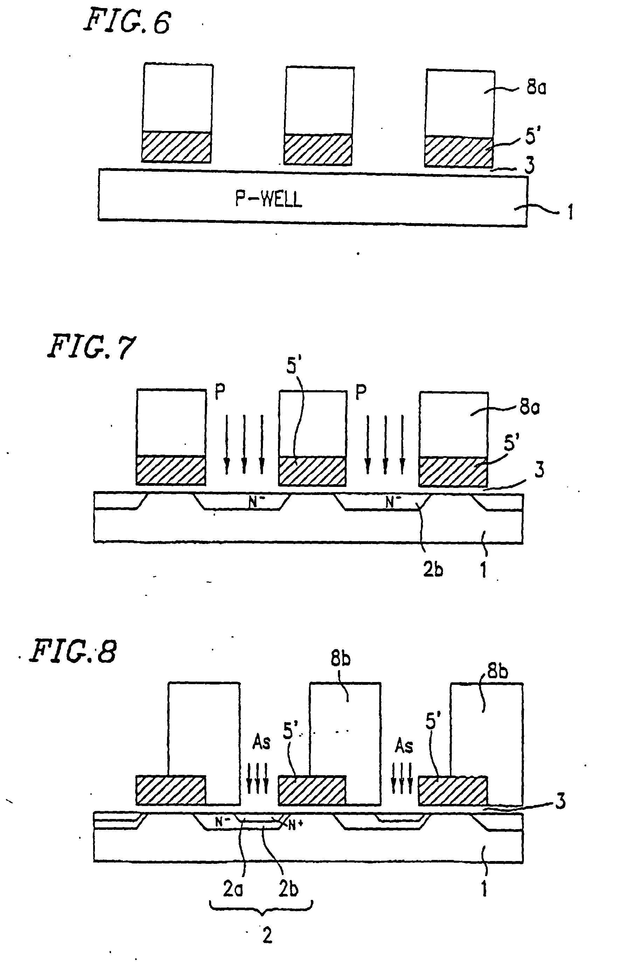

Referring to Figures 6 to 10, a first example of the fabrication method of a nonvolatile semiconductor memory according to the present invention will be described. In this example, the fabrication method of the nonvolatile semiconductor memory 100 of Example 1 will be described. Figures 6 to 10 are sectional views taken along line A-A of Figure 1, showing steps of the fabrication method.

First, the field insulating films (element isolation films) 12 shown in Figure 2B are formed on the semiconductor substrate (silicon substrate) 1. Then, the tunnel insulating film 3 with a thickness of about 80 Å is formed, by thermal oxidation, and first polysilicon is deposited on the tunnel insulating film 3 to a thickness of about 1000 to 2000 Å. A first resist mask 8a with a predetermined pattern is formed on the first polysilicon by photolithography, to form first polysilicon layers 5' in a striped shape by patterning. Each of the first polysilicon layers 5' has the same width as the width in the channel direction of the floating gate 5 to be formed in a later step (Figure 6).

Thereafter, phosphorous ions are implanted with an energy of 50 KeV and a dose amount of 3 × 10¹³/cm². The regions where the phosphorous ions are implanted will become the low-density n-type impurity diffusion layers (source diffusion layers) 2b in a later step (Figure 7). Then, after removing the first resist mask 8a, a second resist mask 8b with a predetermined pattern having openings corresponding to regions which will become the drain diffusion layers in a later step is formed. Using the second resist mask 8b, arsenic ions are implanted with an energy of 70 KeV and a dose amount of 1 x 10¹⁵/cm². The regions where the arsenic ions are implanted will become the high-density N-type impurity diffusion layers (drain diffusion layers) 2a in a later step (Figure 8). After the second resist mask 8b is removed, the resultant structure is heat-treated under a nitrogen atmosphere at 900°C for 10 minutes, so that a DDD structure is formed in the drain diffusion layers 2a, while an LDD structure is formed in the source diffusion layers 2b. The high-density impurity diffusion layer 2a and the low-density impurity diffusion layer 2b constitute one continuous diffusion layer 2, and a series of the diffusion layers 2 in the Y direction constitute a one bit line.

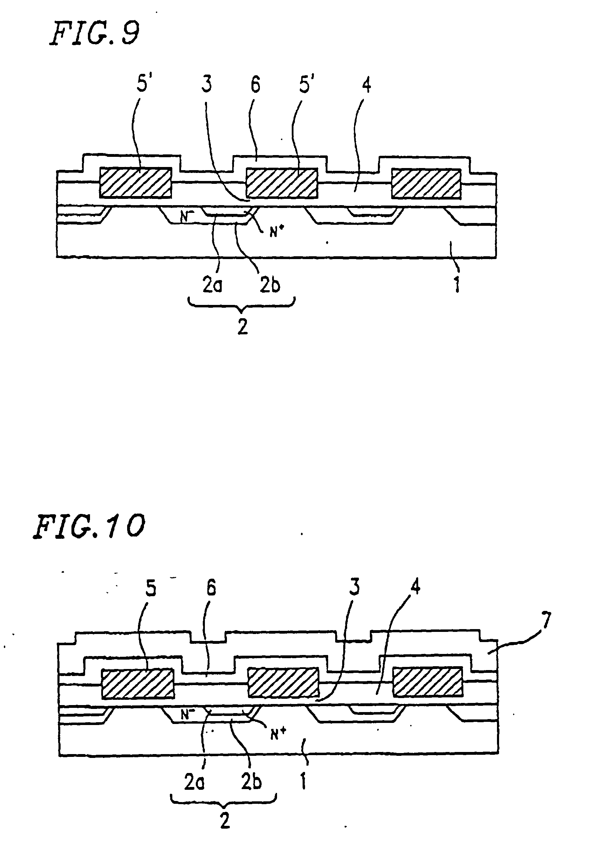

An oxide film is formed by CVD and etched back to form oxide films 4 between the first polysilicon layers 5'. The ONO film (oxide film/nitride film/oxide film) 6 is formed on the resultant structure (Figure 9). Then, a second polysilicon film 7' with a thickness of about 1000 Å is formed on the ONO film 6. By patterning the second polysilicon layer 7', the ONO film 6, and the first polysilicon layers 5' by photolithography (see Figure 2B), the control gates 7, the insulating films 6, and the floating gates 5 are formed (Figure 10). The control gates 7 of respective memory cells are formed consecutively in the X direction, forming one word line.

Alternatively, the control gates 37 (i.e., the word line WL) may be of a double-layered structure where metal silicide with a high melting point such as tungsten silicide (WSi) is deposited to a thickness of about 1000 Å on the second polysilicon layer with a thickness of about 1000 Å and these layers are patterned.

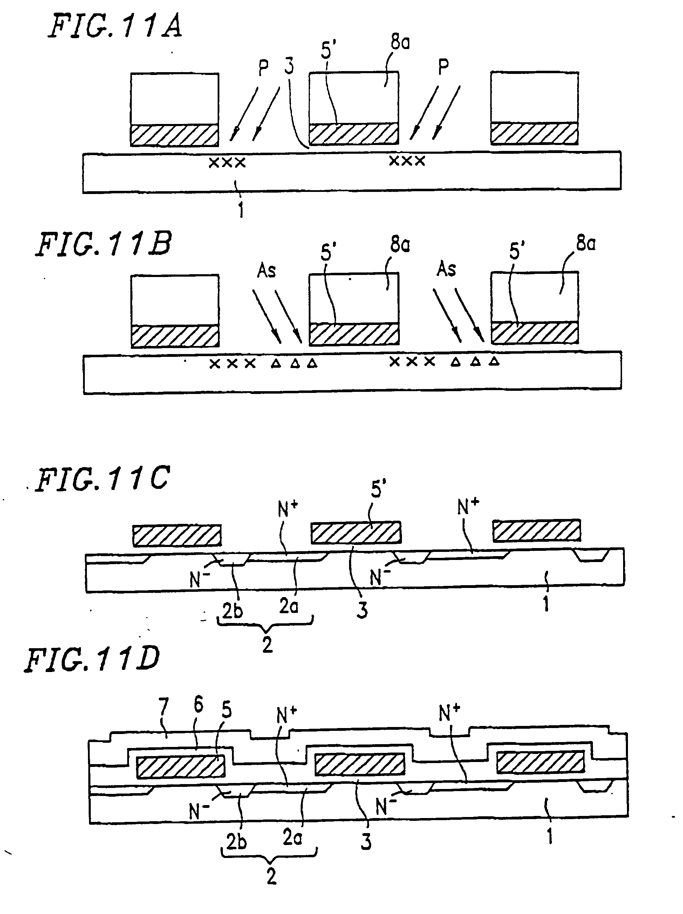

Next, an alternative fabrication method of the nonvolatile semiconductor memory according to the present invention will be described with reference to Figures 11A to 11D. In the above fabrication method, the first and second resist masks 8a and 8b are used. In response to the recent request for a smaller memory cell array, the spaces between the adjacent floating gates 5 are made smaller. This makes it difficult to form the second resist mask 8b. To overcome this problem, in this alternative method, both phosphorous and arsenic ions are implanted using the first resist mask 8a.

The step until the first resist mask 8a is formed on the semiconductor substrate 1 is the same as that in the above method (Figure 6). Then, as shown in Figure 11A, phosphorous ions are implanted to form the low-density impurity diffusion layer. At this time, by implanting phosphorous ions at a predetermined tilt angle (e.g., about 7° with respect to the normal of the semiconductor substrate 1), the phosphorous ions are implanted in the portions of the semiconductor substrate along one side (source side) of each of the openings of the first resist mask 8a (corresponding to the bit lines). This implantation does not form the DDD structure, but is suitable for miniaturization.

Phosphorous ions may be implanted on only the source side as described above, or, as in the case shown in Figure 7, may be implanted so that the DDD structure is formed.

Thereafter, as shown in Figure 11B, arsenic ions are implanted at a predetermined tilt angle (e.g., about 7° inversely with respect to the normal of the semiconductor substrate 1). Thus, arsenic ions are implanted in the portions of the semiconductor substrate along the other side (drain side) of each of the openings of the first resist mask 8a. The first resist mask 8a is then removed and the resultant structure is heat-treated, forming the diffusion layers 2 each including the high-density N-type diffusion layer 2a on the drain side and the low-density N-type diffusion layer 2b on the source side consecutively (Figure 11C). The ONO films 6 and the control gates 7 are then formed in a manner similar to the steps shown in Figures 9 and 10 (Figure 11D).

According to the above tilt ion implantation, the step of forming the second resist mask 8b can be omitted and an allowance for alignment is not required. Thus, the cell size can be further reduced.

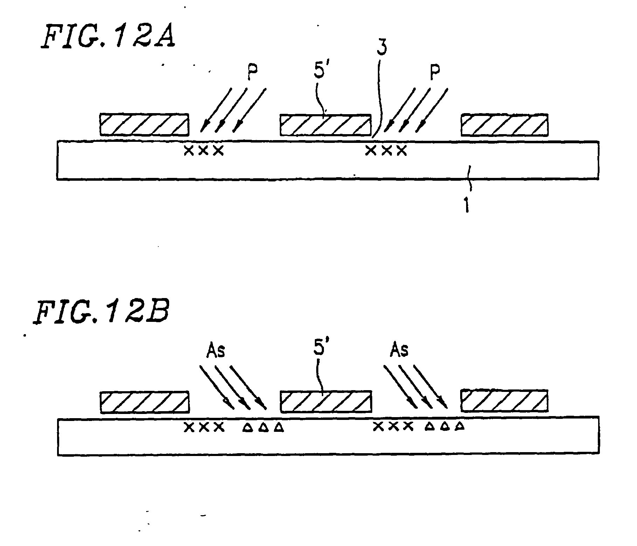

In the above alternative method, phosphorous and arsenic ions may be implanted after the removal of the first resist mask 8a as shown in Figures 12A and 12B. In this case, the tilt angle for ion implantation should be larger than the case using the resist mask 8a.

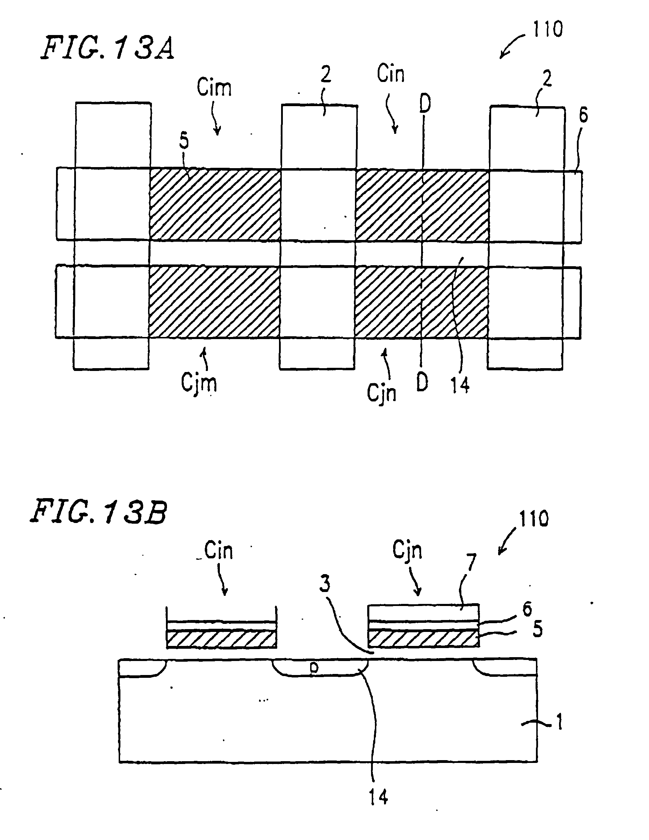

Figures 13A and 13B show an alternative nonvolatile semiconductor memory according to the present invention. A nonvolatile semiconductor memory 110 does not include the field oxide films 12 (see Figure 2B) on the semiconductor substrate I, but includes p-type impurity diffusion layers 14 to isolate memory cells lined in the Y direction from one another.

The fabrication process of the nonvolatile semiconductor memory 110 is almost the same as those described above (see Figures 6 to 10, 11A to 11D, and 12A and 12B). The p-type impurity diffusion layers 14 for element isolation are formed by implanting phorone ions with an energy of 40 KeV and a dose amount of 1 × 10¹³/cm² using the control gates (word lines) as the mask after the formation of the control gates (word lines) (Figure 13B).

Since a pattern for forming an element isolation film is not required, the distance between the memory cells adjacent in the Y direction can be made smaller to the limit of the resolution for photolithography.

### (Example 3)

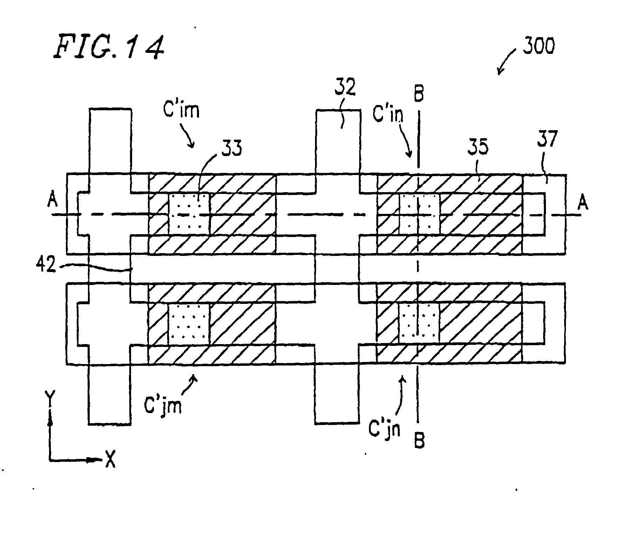

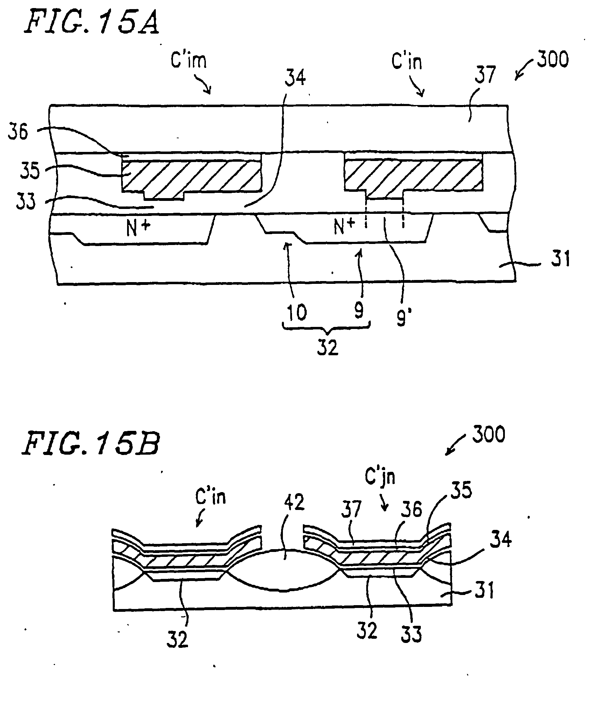

Figure 14 is a plan view of a portion of a memory cell array of a nonvolatile semiconductor memory 300 of Example 3, not forming part of the present invention. Figures 15A and 15B are sectional views of the nonvolatile semiconductor memory 300 taken along lines A-A and B-B of Figure 14, respectively,

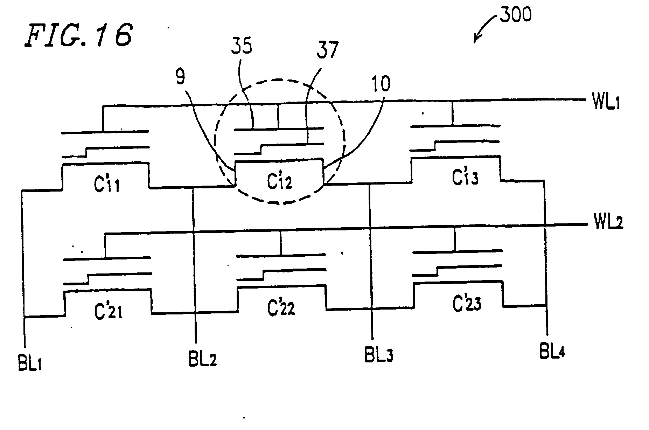

Referring to Figures 14, 15A, and 15B, the nonvolatile semiconductor memory 300 includes a plurality of memory cells C' formed in a matrix on a semiconductor substrate 31. In Figure 14, the respective memory cells C' are denoted by individual codes such as C'ᵢₙ. Each of the memory cells C' includes a floating gate 35 formed on the semiconductor substrate 31 via an insulating film. A control gate 37 is formed on the floating gate 35 via an insulating film 36 made of ONO and the like. Such control gates 37 extend in a channel direction of the memory cell C' (an X direction shown in Figure 14), constituting a word line WL as shown in Figure 16 for connecting the memory cells C' lined in the X direction.

As shown in Figures 14 and 15A, a high-density n-type diffusion layer 32 is formed between two memory cells adjacent in the x direction (e.g., memory cells C'ᵢₙ and C'ᵢₙ). The diffusion layer 32 includes a drain diffusion layer 9 for one of the two adjacent memory cells (e.g., the memory cell C'ᵢₙ) and a source diffusion layer 10 for the other memory cell (e.g., the memory cell C'ᵢₙ). The diffusion layer 32 is thus shared by the two adjacent memory cells.

As shown in Figures 14 and 15A, a tunnel insulating film 33 and a gate insulating film 34 are formed underneath each of the floating gate 35. The tunnel insulating film 33 is formed above the diffusion layer 32 and thinner than the gate insulating film 34. Thus, when a predetermined voltage is applied between the floating gate 35 and the semiconductor substrate 31, a tunnel current flows through the tunnel insulating film 33, while it does not flow through the gate insulating film 34.

In each memory cell C', the floating gate 35 is capacitively coupled with the drain diffusion layer 9 of one of the two diffusion layers 32 located on both sides of the memory cell C' via the tunnel insulating film 33 on the drain side (defining a tunnel region 9'), while it is capacitively coupled with the source diffusion layer 10 of the other diffusion layer 32 via the gate insulating film 34 on the source side. Thus, the transistor of the memory cell C' in this example is an asymmetric transistor where the insulating film is formed asymmetrically between the drain side and the source side. The tunnel insulating film 33 may be composed of a silicon oxide film or a lamination of a silicon oxide film and a silicon nitride film.

In this example, the diffusion layers 32 lined in the Y direction are connected with one another via diffusion layer wirings, forming a so-called buried bit line. Alternatively, the diffusion layers 32 may be electrically connected via metal wirings. In the latter case, a contact region is required for each diffusion layer 32. As shown in Figure 15B, a field oxide film (element isolation film) 42 is formed between the floating gates 35 of two adjacent memory cells in the Y direction (e.g., the memory cells C'ᵢₙ and C'ⱼₙ) .

As shown in the equivalent circuit of Figure 16, the nonvolatile semiconductor memory 300 employs the virtual ground method, where bit lines BL (bit lines BL₁ to BL₄ are shown in Figure 16) serve as the source wirings or the drain wirings depending on the selected cell.

The operation of the nonvolatile semiconductor memory 300 will now be described. Table 2 below shows the operation conditions when the memory cell C'₁₂ shown in Figure 16 is selected, for example.

**TABLE 2**

| Operation mode | Word line voltage (V) | | Bit line voltage (V) | | | |
|---|---|---|---|---|---|---|
| | Selected | Non-selected | BL₁ | BL₂ | BL₃ | BL₄ |
| | WL₁ | WL₂ | | | | |
| Write | -6 | 0 | Float | 3 | Float | Float |
| Erase | 12 | 0 | 0 | 0 | 0 | 0 |
| Read | 3 | 0 | 0 | 0 | 1 | 1 |

In the write operation, a negative high voltage V_{H1} (e.g., -6 V) is applied to the word line WL₁ connected with the control gate 37 of the memory cell C'₁₂, while 0 V is applied to the other word lines. A predetermined positive voltage V_{cc} (e.g., 3 V) is applied to the bit line BL₂ connected with the drain of the memory cell C'₁₂, while the other bit lines are put in the floating state. In the memory cell C'₁₂ of the above state, a tunnel current flows from the drain diffusion layer 9 to the floating gate 35 via the tunnel insulating film 33 due to the electric field applied between the floating gate 35 and the drain diffusion layer 9, allowing data to be written in the memory cell C'₁₂.

The same write voltage is also applied to the control gate 37 of the non-selected cell C'₁₁, which is connected with the word line WL₁ and the source diffusion layer 10 of the bit line BL₂. However, since the comparatively thick gate insulating film 34 which does not cause the tunnel phenomenon is formed above the source diffusion layer 10, no tunnel current flows between the source diffusion layer 10 and the floating gate 35 of the non-selected cell C'₁₁. Accordingly, though the non-selected cell shares the diffusion layer 32 with the selected cell, no data is written in the non-selected cell.

In the erase operation, first, 0 V is applied to all the bit lines BL. Then, a positive high voltage V_{H2} (e.g., 12 V) is applied to a desired word line WL. This allows electrons to be injected into the floating gates 35 of a plurality of memory cells simultaneously, and thus data stored in the memory cells are erased at one time. For example, when a high voltage V_{H2} is applied to the word line WL₁, data in the memory cells C'₁₁, C'₁₂, and C'₁₃ are erased at one time. When a high voltage V_{H2} is applied to the word line WL₂, data in the memory cells C'₂₁, C'₂₂, and C'₂₃ are erased at one time.

The data reading from the selected cell C'₁₂ is conducted in a conventional manner. First, a predetermined voltage V_{cc} (e.g., 3 V) is applied to the word line WL₁. Simultaneously, a predetermined voltage V_{L} (e.g., 1 V) is applied to the bit line BL₃, and 0 V is applied to the bit line BL₂. Data is read by detecting a current flowing between these bit lines.

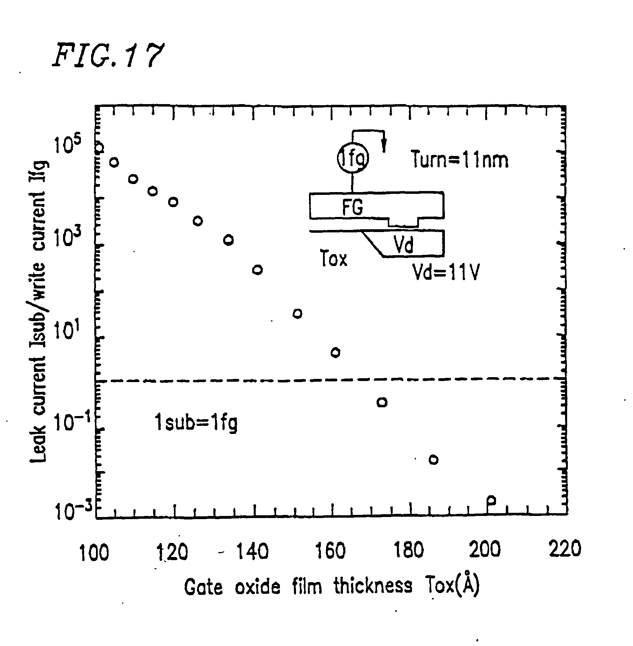

Now, the dependency of the current flowing into the semiconductor substrate 31 upon the thickness of the gate insulating film 34 when a predetermined voltage is applied to the floating gate 35 in the write operation will be described. Figure 17 is a graph plotting the ratio of the leakage current (i.e., the current flowing into the semiconductor substrate 31) to the write current (i.e., the tunnel current flowing between the drain diffusion layer 9 and the floating gate 35) with respect to the thickness of the gate insulating film 34. The thickness of the tunnel insulating film 33 is 11 nm (110 Å). As is observed from Figure 17, when the thickness of the gate insulating film 34 is 17 nm or more, the leakage current flowing into the semiconductor substrate 31 is smaller than the tunnel current. Thus, by comparatively thickening the gate insulating film 34, the write efficiency can be improved. Since the voltage applied in the write operation can be reduced by thinning the tunnel insulating film 33, the gate insulating film 34 can be thinned in proportion to the thinning of the tunnel insulating film 33. Also, the voltage can be lower than the case of the memory cells in Example 1.

In this example, the asymmetric memory cell can be realized by varying the thickness of the gate insulating film. Alternatively, it can be realized by forming the tunnel insulating film of a different material from that of the other portion of the insulating film.

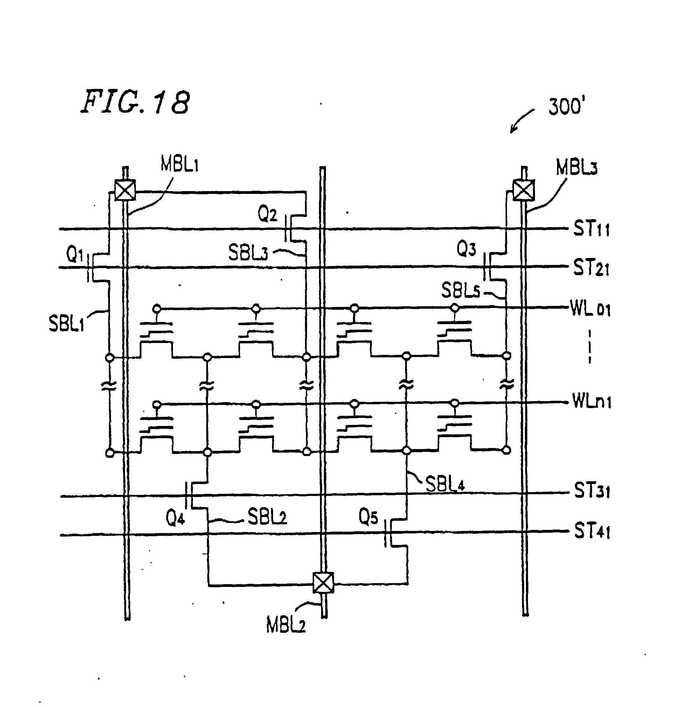

Figure 18 shows an example of an equivalent circuit of a nonvolatile semiconductor memory cell array 420 where, in order to reduce the wiring resistance of the bit line BL composed of the diffusion layers shown in Figure 16, a sub-bit line SBL is connected to a main bit line MBL made of metal via a selective transistor.

### (Example 4)

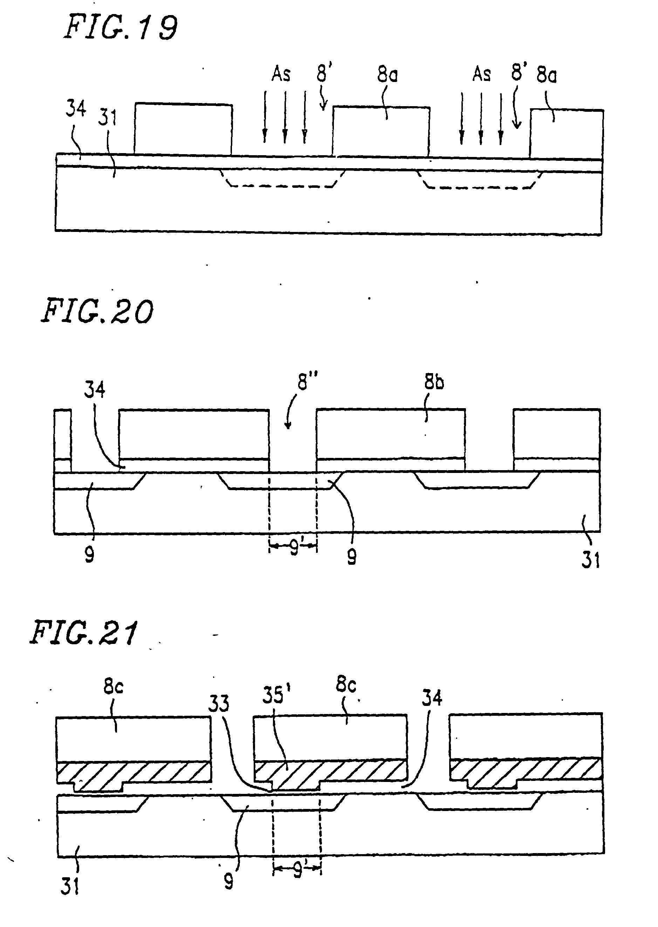

Referring to Figures 19 to 23, a second illustrative example of the fabrication method of a nonvolatile semiconductor memory will be described. In this example, the fabrication method of the nonvolatile semiconductor memory 300 shown in Figure 14 will be described.

First, the field insulating films (element isolation films) 42 shown in Figure 15B are formed on the semiconductor substrate (silicon substrate) 31. Then, the gate insulating film 34 with a thickness of about 200 Å (20 nm) is formed by thermal oxidation. A first resist mask 8a with a predetermined pattern is formed on the gate insulating film 34 by photolithography. The first resist mask 8a has openings 8' at positions corresponding to regions which will become drain diffusion layers 9 in a later step. Arsenic ions are implanted using the first resist mask 8a with an energy of 70 KeV and a dose amount of 5 × 10¹⁵/cm² (Figure 19).

After the first resist mask 8a is removed, the resultant structure is heat-treated under a nitrogen atmosphere at 900°C for 30 minutes so that the drain diffusion layers 9 which are high-density n-type diffusion layers are formed. Thereafter, a second resist mask 8b with a predetermined pattern having openings 8" corresponding to regions which will become tunnel regions 9' in a later step is formed by photolithography. Using the second resist mask 8b, the portions of the gate insulating film 34 located above the tunnel regions 9' are removed (Figure 20).

The tunnel insulating films 33 with a thickness of about 80 Å are formed in the tunnel regions 9', and first polysilicon is deposited on the insulting films to a thickness of about 1500 Å. A third resist mask 8c with a predetermined pattern is formed on the first polysilicon by photolithography. Using the third resist mask 8c, the first polysilicon is patterned to form first polysilicon layers 35' in a striped shape. Each of the first polysilicon layers 35' has the same width as the width in the channel direction of the floating gates 35 to be formed in a later step (Figure 21).

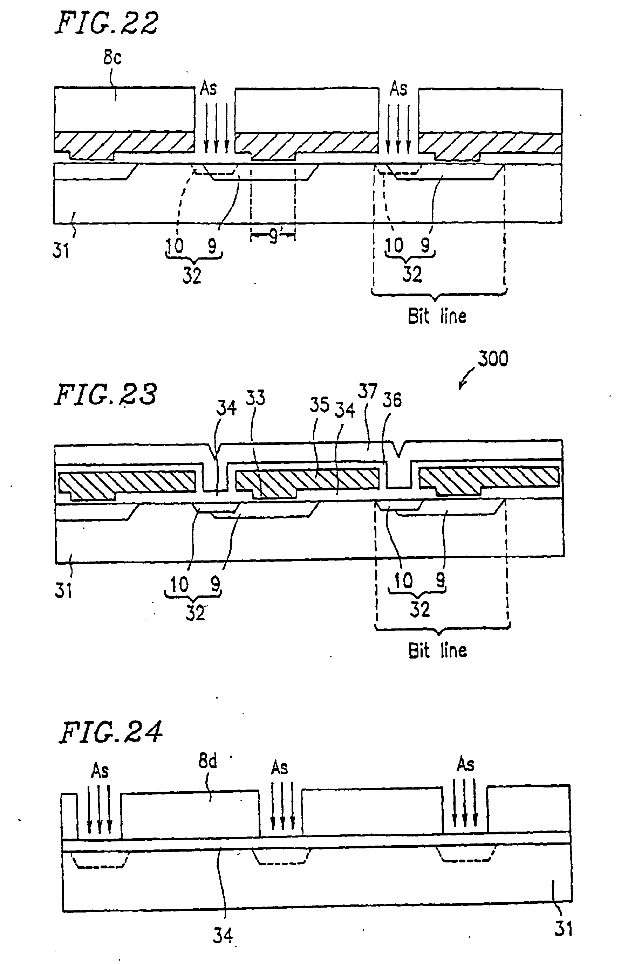

Thereafter, using the first polysilicon layer 35' as the mask, arsenic ions are implanted with an energy of 70 KeV and a dose amount of 1 × 10¹⁵/cm² (Figure 22). After the third resist mask 8c is removed, the resultant structure is heat-treated under a nitrogen atmosphere at 900°C for 30 minutes, thereby to form the source diffusion layers 10. The source diffusion layer 10 of each memory cell is in contact with the drain diffusion layer 9 of an adjacent memory cell, jointly forming the diffusion layer (bit line) 32.

The ONO film (oxide film/nitride film/oxide film) 36 is formed on the resultant structure by CVD, and then a second polysilicon layer 37' with a thickness of about 1000 Å is formed on the ONO film 36. The second polysilicon layer 37', the ONO film 36, and the first polysilicon layers 35' are then patterned by photolithography (see Figure 15B), to form the control gates 37, the insulating films 36, and the floating gates 35 (Figure 23). The control gates 37 of the respective memory cells are formed consecutively, forming the word line.

Alternatively, the control gates (word line) 37 may be of a double-layered structure where metal silicide with a high melting point such as tungsten silicide (WSi) is deposited to a thickness of about 1000 Å on the second polysilicon layer with a thickness of about 1000 Å and these layers are patterned.

Next, an alternative fabrication method of the nonvolatile semiconductor memory will be described with reference to Figures 24 to 28. In the above fabrication method, in order to cover the entire tunnel region with the diffusion layer, two different masks 8a and 8b for ion implanting to form the drain diffusion layer and to define the tunnel region, respectively, are used. Since allowances for aligning the respective masks are required at the formation of these masks, the size reduction of the memory cells is restricted. To overcome this problem, in this alternative method, impurity ions are implanted using the mask for defining the tunnel region, so as to form the diffusion layer in the tunnel region in a self-alignment manner.

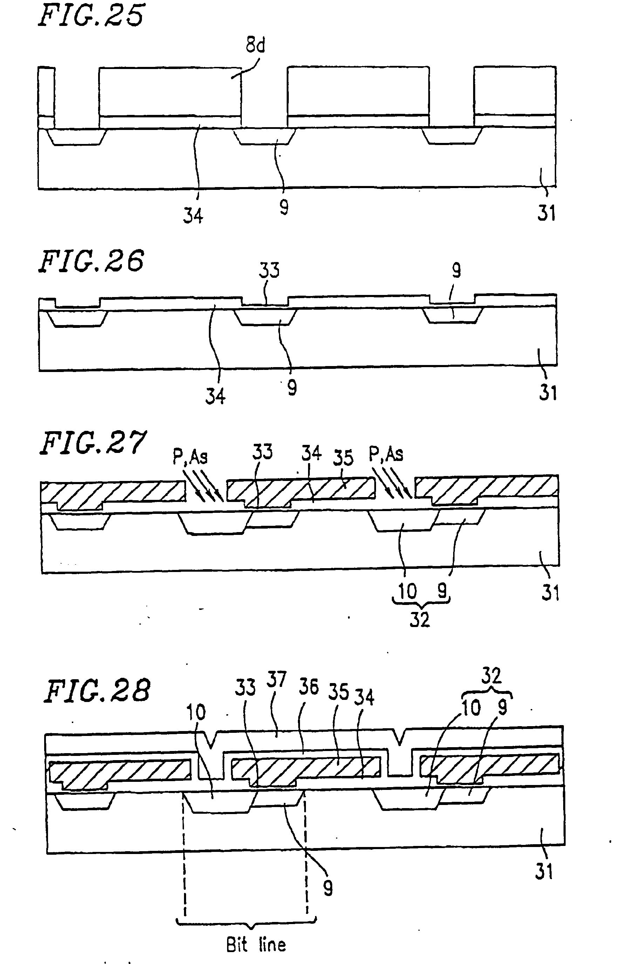

First, as in the above fabrication method, the gate insulating film (first gate insulating film) 34 with a thickness of about 200 Å (20 nm) is formed by thermal oxidation on the semiconductor substrate 31 having the field insulating films (element isolation films) 42 formed thereon. A resist mask 8d with a predetermined pattern having openings corresponding to regions which will become tunnel regions in a later step is formed on the gate insulating film by photolithography. Using the resist mask 8d, arsenic ions are implanted with an energy of 70 KeV and a dose amount of 5 × 10¹⁵/cm² (Figure 24). Then, still using the resist mask 8d, the portions of the gate insulating film 34 located above the tunnel regions are removed (Figure 25).

After the resist mask 8d is removed, the resultant structure is heat-treated under a nitrogen atmosphere at 900°C for 10 minutes, forming the drain diffusion layers 9 which are high-density n-type diffusion layers. The tunnel insulating films (second gate insulating films) 33 with a thickness of about 80 Å are then formed by thermal oxidation at 900°C for 10 minutes (Figure 26).

A first polysilicon film with a thickness of about 1000 to 2000 Å is formed, which is then patterned by photolithography using a resist mask with a predetermined pattern to form the first polysilicon layers 35' in a striped shape. Each of the first polysilicon layers 35' has the same width as the width in the channel direction of the floating gates 35 to be formed in a later step. After the resist mask is removed, phosphorous ions are implanted at a tilt angle of about 45° with respect to the normal of the semiconductor substrate 31 (tilt ion implantation) with an energy of 30 KeV and a dose amount of 1 to 5 × 10¹⁴ 10m². Subsequently, still using the first polysilicon layers 35' as the mask, arsenic ions are implanted by tilt ion implantation with an energy of 70 KeV and a dose amount of 1 × 10¹⁵ /om² (Figure 27). Only one-time implantation of either phosphorous ions or arsenic ions is acceptable. However, the contact with the diffusion layers 9 under the tunnel insulating films 33 can be more ensured by the two-time implantation of phosphorous ions and arsenic ions as described above. Thereafter, the source diffusion layers 10 are formed by predetermined heat-treatment. The source diffusion layer 10 of one memory cell is in contact with the drain diffusion layer 9 of an adjacent memory cell, jointly forming the diffusion layer (bit line) 32.

The ONO film 36 is formed on the resultant structure by CVD, and then the second polysilicon layer 37' with a thickness of about 1000 Å is formed on the ONO film 36. The second polysilicon layer 37', the ONO film 36, and the first polysilicon layers 35' are then patterned (see Figure 15B) to form the control gates 37, the insulating films 36 and the floating gates 35 (Figure 28). The control gates 37 of the respective memory cells are formed consecutively, forming the word line.

Alternatively, the control gates (word line) 37 may have a double-layered structure where metal silicide with a high melting point such as tungsten silicide (WSi) is deposited to a thickness of 1000 Å on the second polysilicon layer of a thickness of about 1000 Å and these layers are patterned.

Thus, according to this example, since the bit line is shared by two adjacent memory cells, the memory cell structure is simplified and the cell size can be reduced. Since all the tunnel regions are formed above the diffusion layers (especially, the drain diffusion layers), a leakage current from the diffusion layers to the semiconductor substrate in the write operation can be reduced. This improves the write efficiency and lowers the power consumption. Since no electron/hole trapping due to the leakage current occurs, the reliability of the memory cells can be improved.

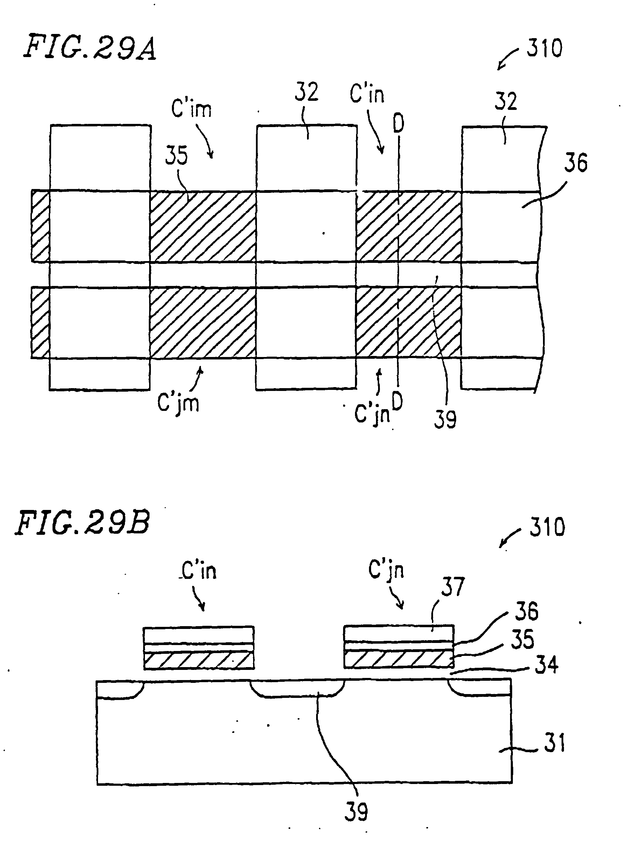

Figures 29A and 29B show an alternative illustrative example of a nonvolatile semiconductor memory. A nonvolatile semiconductor memory 310 does not include the field oxide films 42 (see Figure 15B) on the semiconductor substrate 31. Instead, it includes p-type impurity diffusion layers 39 to isolate memory cells lined in the Y direction from one another.

The fabrication process of the nonvolatile semiconductor memory 310 is almost the same as those described above (see Figures 19 to 23, and Figures 24 to 28). The p-type impurity diffusion layers 39 are formed by implanting phorone ions under the condition of an energy of 40 KeV and a dose amount of 1 × 10¹³/cm² using the control gates (word lines) 37 as the mask after the formation of the control gates (word lines) 37 (Figure 29B).

### (Example 5)

In Example 5, a nonvolatile semiconductor memory 320 using asymmetric transistors where the insulating film is formed asymmetrically between the drain side and the source side, as the nonvolatile semiconductor memory 300 of Example 3, will be described.

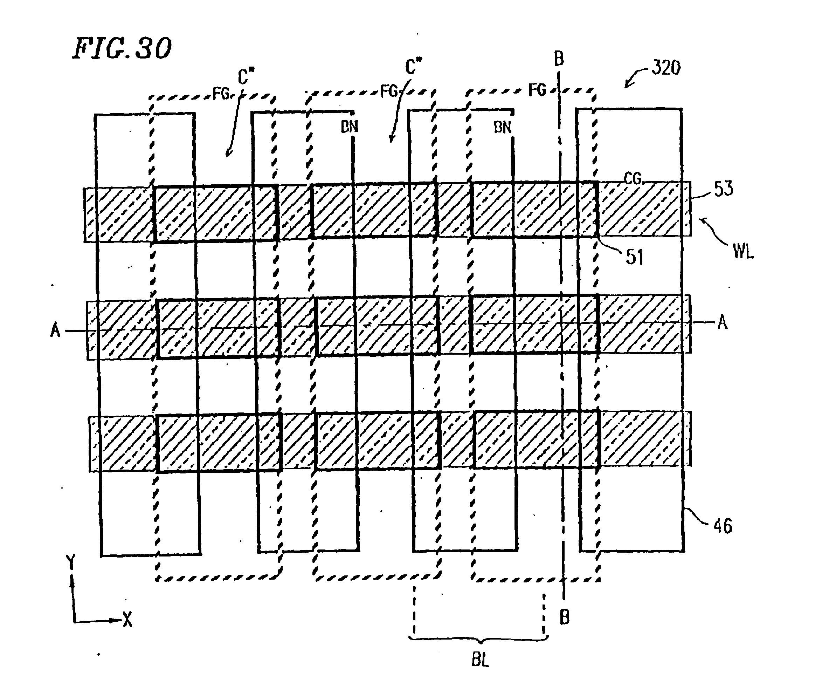

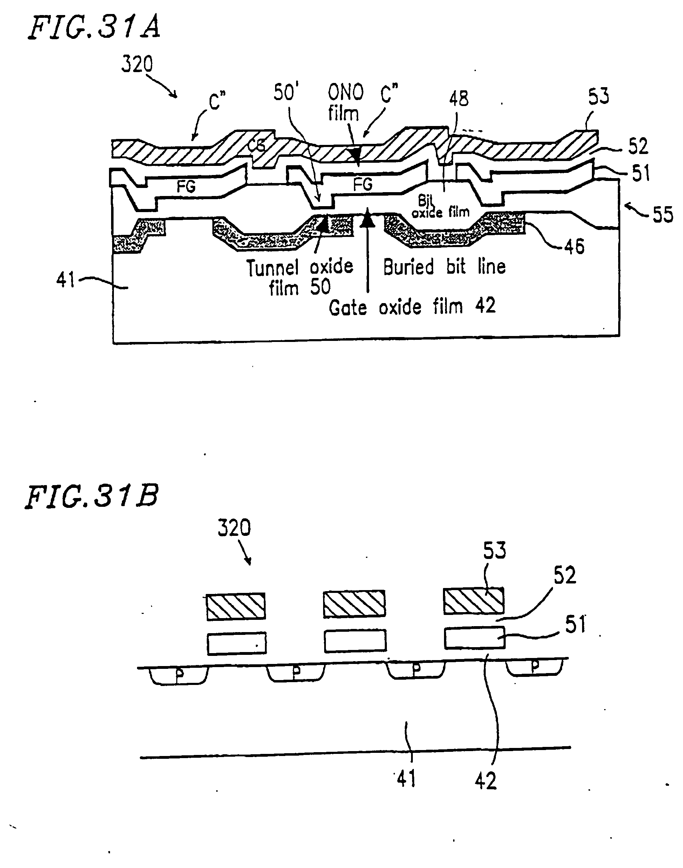

Figure 30 is a plan view of a portion of a memory cell array of the nonvolatile semiconductor memory 320 of this example. Figures 31A and 31B are sectional views of the nonvolatile semiconductor memory 320 taken along lines A-A and B-B of Figure 30, respectively,

Referring to Figures 30, 31A, and 31B, the nonvolatile semiconductor memory 320 includes a plurality of memory cells C" formed in a matrix on a semiconductor substrate 41. In each memory cell C", a floating gate 51 is formed on the semiconductor substrate 41 via an insulating film 55. As shown in Figure 31A, the insulating film 55 is not uniform in thickness, including a gate insulating film (first gate insulating film) 42, a tunnel insulating film (second gate insulating film) 50, and a bit line insulating film 48 of different thicknesses.

A control gate 53 is formed on the floating gate 51 via an insulating film 52 made of ONO and the like. Such control gates 53 extend in a channel direction of the memory cell C" (an X direction shown in Figure 30), constituting a word line WL for connecting the memory cells C" lined in the X direction.

As shown in Figures 30 and 31A, a high-density n-type diffusion layer 46 is formed between two memory cells adjacent in the x direction. The diffusion layer 46 includes a drain diffusion layer for one of the two adjacent memory cells and a source diffusion layer for the other memory cell. The diffusion layer 46 is thus shared by the two adjacent memory cells. The diffusion layers 46 lined in the Y direction are connected via diffusion layer wirings, forming a buried bit line.

The gate insulating film 42 and the tunnel insulating film 50 are formed underneath the floating gate 51. All the tunnel insulating films 50 are formed above the diffusion layers 46. Each of the diffusion layers 46 is capacitively coupled with the floating gate 51 of one of the adjacent memory cells via the tunnel insulating film 50 on the drain side (defining a tunnel region 50'), while it is capacitively coupled with the floating gate 51 of the other memory cell via the gate insulating film 42 on the source side. The tunnel insulating film 50 is thinner than the gate insulating film 42. Thus, when a predetermined voltage is applied between the floating gate 51 and the semiconductor substrate 41, a tunnel current flows through the tunnel insulating film 50, while it does not flow through the gate insulating film 42.

Thus, the transistor of the memory cell C" in this example is an asymmetric transistor where the insulating film is formed asymmetrically between the drain side and the source side. The tunnel insulating film 50 may be composed of a silicon oxide film or a lamination of a silicon oxide film and a silicon nitride film. The bit line insulating films 48 with a comparatively large thickness are formed above the portions of the diffusion layers 46 other than the drain and source diffusion layers (i.e., in the regions located between adjacent memory cells).

The nonvolatile semiconductor memory 320 employs the virtual ground method, where the bit lines BL serve as the source wirings or the drain wirings depending on the selected cell.

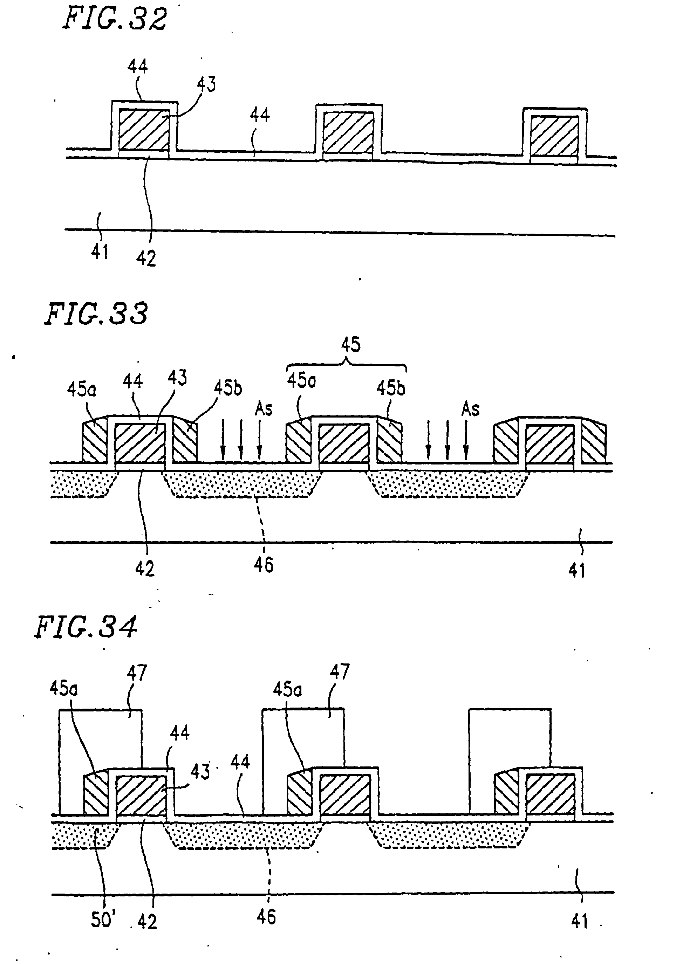

The fabrication method of the nonvolatile semiconductor memory 320 will now be described with reference to Figures 32 to 38.

First, the gate insulating film 42 with a thickness of about 40 nm, for example, is formed on the semiconductor substrate (silicon substrate) 41. Then, a first silicon nitride film 43 of a thickness of about 100 nm, for example) is formed on the gate insulating film 42 and patterned into a predetermined stripe shape. The first silicon nitride film 43 serves as a substantial mask for forming the buried bit lines (diffusion layers). After the patterning of the silicon nitride films 43, an oxide film 44 with a thickness of about 40 nm, for example, is formed over the semiconductor substrate 41 (Figure 32).

A second silicon nitride film 45 is formed on the oxide film 44 and etched back to form nitride film spacers 45 on both side walls of each of the first silicon nitride films 43 covered with the oxide film 44. Each of the nitride film spacers 45 is composed of a nitride film spacer 45a corresponding to the drain side (tunnel region) and a nitride film spacer 45b corresponding to the source side. Using the first silicon nitride films 43 and the nitride film spacers 45 as the mask, arsenic ions are implanted, forming the high-density N-type impurity diffusion layers 46 by heat treatment (i.e., the bit lines BL) (Figure 33).

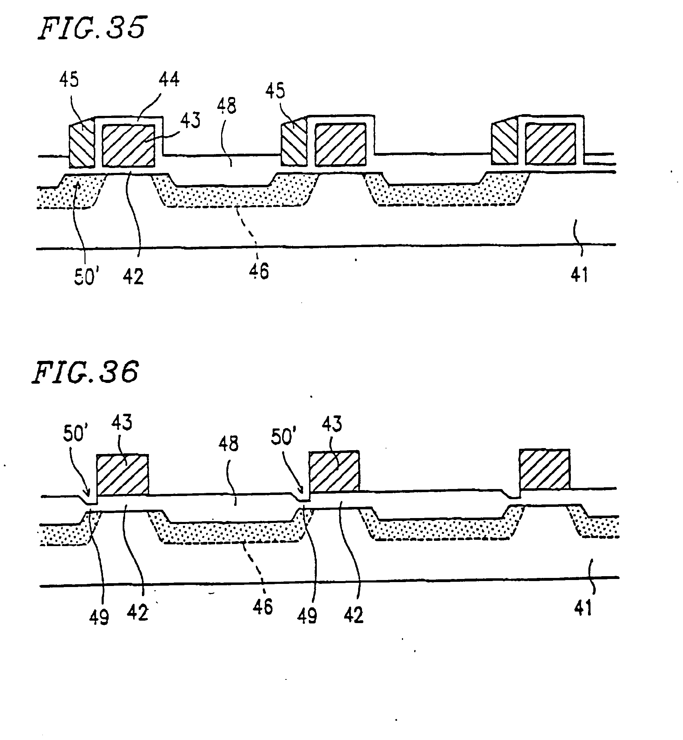

Thereafter, a resist mask 47 with a predetermined pattern is formed to cover the nitride film spacers 45a corresponding to the tunnel regions 50' to be formed in a later step, and the nitride film spacers 45b are removed by isotropic plasma etching using the resist mask 47 (Figure 34). Then, the comparatively thick oxide films 48 (thickness: about 150 nm, for example) are formed on the semiconductor substrate 41, covering the diffusion layers 46 (i.e., the bit lines BL) (Figure 35).

The nitride film spacers 45a and then the oxide films 44 are removed by etching. The portions of the oxide films 44 located above the tunnel regions 50' are completely removed by removing the thermal oxide films (44 and 48) by the thickness of the oxide films 44 (about 40 nm) by etching. By this etching, since the oxide films 48 are sufficiently thick, the portions of the semiconductor substrate other than the tunnel regions 50' will not be exposed. In a subsequent thermal oxidation step, thin thermal oxide films 49 (thickness: about 10 nm, for example) are formed on the tunnel regions 50' (Figure 36).

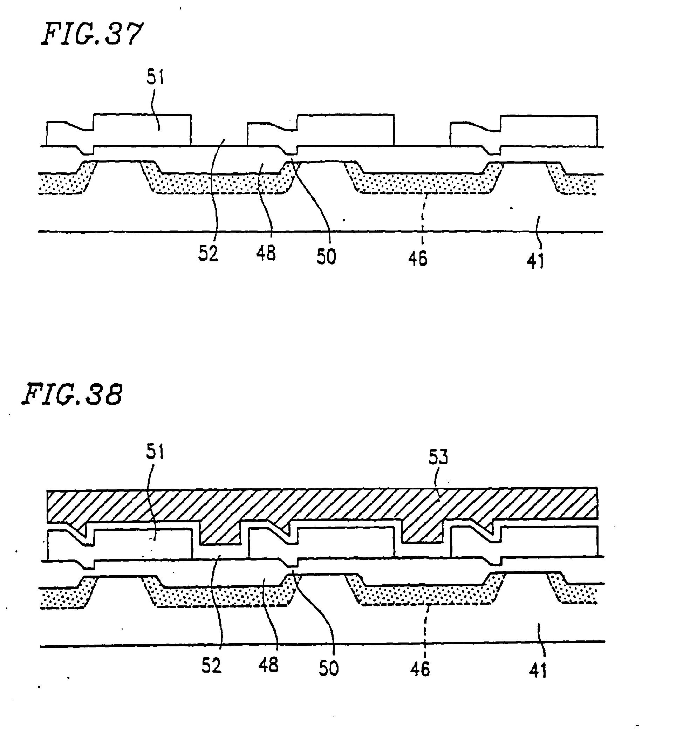

Thereafter, the first silicon nitride films 43 are completely removed by phosphorous boiling, for example. The oxide films 49 are then removed by etching, to expose only the portion of the semiconductor substrate which is to be the tunnel regions 50'. Then, the tunnel insulating films 50 (thickness: about 8 nm, for example) are formed by thermal oxidation. Subsequently, a first polysilicon film with a thickness of about 1500 Å, for example, is formed on the resultant structure, and patterned into a predetermined shape by photolithography, forming the floating gates 51 (Figure 37). After the ONO film 52 is formed by CVD, covering the floating gates 51, a second polysilicon film with a thickness of about 1000 Å, for example, is formed on the ONO film 52 and patterned by photolithography, forming the control gates 53 (Figure 38). The control gates 53 of the respective memory cells are formed consecutively, forming the word line.

The first polysilicon film may be formed in the shape of strips each having the same width as the width in the channel direction of the floating gates 51 and then patterned simultaneously with the second polysilicon film. The control gates 53 may be the word line with the double-layered structure where metal silicide with a high melting point such as tungsten silicide (WSi) is deposited to a thickness of about 100 nm on the second polysilicon layer with a thickness of about 100 nm and these layers are patterned.

Thus, each transistor of this example is an asymmetric transistor having an insulating film including portions with different thicknesses (the gate insulating film 48 and the tunnel insulating film 50) underneath the floating gate 51. In this example, the tunnel region 50' is defined by the nitride film spacer 45a formed on the side walls of the first nitride film 43. This makes it possible to reduce the regions where the tunnel insulating films 50 are formed.

Since all the tunnel regions 50' are formed on the diffusion layers 46, the generation of an interband tunnel current in the write operation can be significantly reduced, improving the write efficiency and the reliability of the memory.

In this example, the capacitance coupling ratio of the control gates increases. This eliminates the necessity of a high voltage transistor module and thus reduces processing costs.

The wiring portions of the diffusion layers 46, i.e., the portions of the diffusion layers 46 other than the source coupling regions and the drain coupling regions (tunnel regions 50') coupled with the floating gates 51 are covered with the comparatively thick insulating films 48. This reduces the parasitic capacitance between the control gates 53 and the bit lines.

### (Example 6)

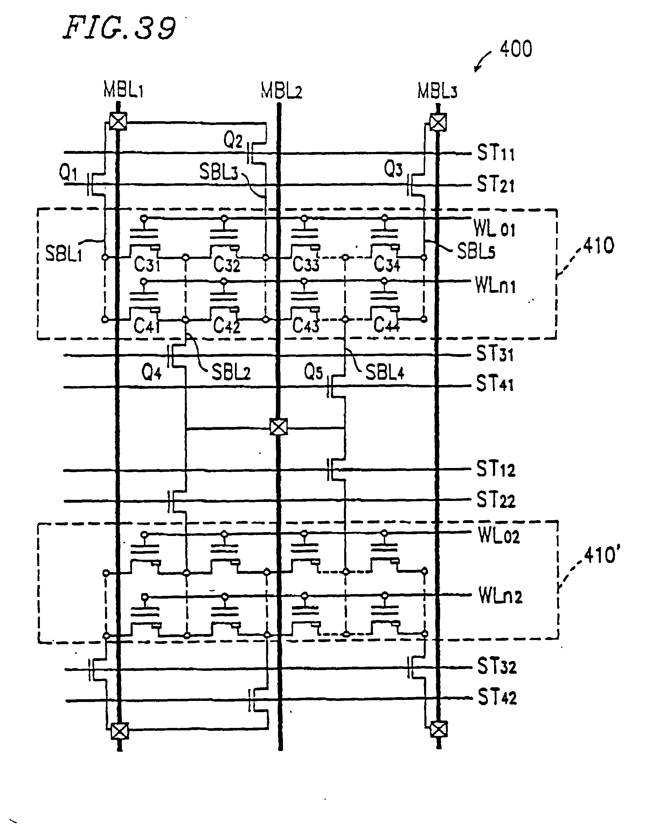

Figure 39 is a plan view showing the configuration of a nonvolatile semiconductor memory 400 of Example 6. A memory cell array of the nonvolatile semiconductor memory 400 is divided into a plurality of blocks 410. This division of the memory cell array into a predetermined number of blocks contributes to reducing the parasitic capacitance and resistance of wirings and increasing the operation speed. In this example, the memory cells C used in the nonvolatile semiconductor memory 100 in Example 1 are used. The configuration of this example can also be applied to the nonvolatile semiconductor memory 300 of Example 3. The operation of such a nonvolatile semiconductor memory obtained by dividing the memory cell array of the nonvolatile semiconductor memory 300 of Example 3 into a plurality of blocks is basically the same as that described hereinbelow. Voltages to be applied may be changed depending on the characteristics of the memory cells.

Referring to Figure 39, the diffusion layers 2 of the nonvolatile semiconductor memory 400 are coupled in the Y direction, forming sub-bit lines SBL (sub-bit lines SBL₁ to SBL₅ are shown in Figure 39). One main bit line MBL is arranged for every two sub-bit lines SBL (main bit lines MBL₁ to MBL₃ are shown in Figure 39). The main bit lines MBL are made of a metal layer and arranged in the same direction as the sub-bit lines SBL at a pitch of every two memory cells C. In this example, the sub-bit lines SBL are diffusion layer wirings, while the main bit lines MBL are metal wirings so that the memory cells can be formed irrelevant of the pitch of the metal wirings, the pitch of the metal wirings can be every two memory cells, and thus the parasitic capacitance of the metal wirings can be reduced.

The sub-bit lines SBL are connected to the corresponding main bit lines MBL via selective transistors. For example, the sub-bit lines SBL₁ and SBL₃ are connected to the main bit line MBL₁ via selective transistors Q₁ and Q₂, respectively, while the sub-bit lines SBL₂ and SBL₄ are connected to the main bit line MBL₂ via selective transistors Q₄ and Q₅, respectively. The selective transistors are controlled via corresponding selective lines ST (selective lines ST₁₁ to ST₄₁, and ST₁₂ to ST₄₂ are shown in Figure 39).

The block 410 includes a plurality of word lines WLₒ₁ to WLₙ₁ (e.g., when n=31, 32 word lines). Incidentally, the right-side number of the subscript of the word line code (01, n1, etc.) represents the block number. The number is therefore 2 for the word lines in a second block 410' shown in Figure 39 (word lines WLₒ₂, WLₙ₂, etc.). The configuration of the block 410 and the arrangement of the main bit lines MBL are not limited to those described above.

When the block 410 is a non-selected block in the erase operation, the selective transistors Q₁ to Q₅ are turned off to electrically isolate all the diffusion layers 2 (sub-bit lines SBL) in the block 410 from the corresponding main bit lines MBL (floating state). This prevents data in the non-selected block from being erased mistakenly even if the erase operation is repeated.

The sub-bit line closest to the boundary of each block is not connected with a memory cell included in the adjacent block.

The operation of the nonvolatile semiconductor memory 400 will now be described. Table 3 shows examples of applied voltages in the respective operation modes when a memory cell C₃₁ is selected.

**TABLE 3**

| Operation mode | Main bit line voltage (V) | | | Word line voltage (V) | | Selective line voltage (V) | | | | |
|---|---|---|---|---|---|---|---|---|---|---|
| | | | | Selected | Non-selected | Selected | | | | Non-selected |
| | MBL₁ | MBL₂ | MBL₃ | WL₀ | WL₃₁ | ST₁₁ | ST₂₁ | ST₃₁ | ST₄₁ | STᵢₙ |
| Write | 4 | Float | Float | -8 | 0 | 0 | 6 | 6 | 0 | 0 |
| Erase | 0 | 0 | 0 | 17 | 17 or 0 | 3 | 3 | 3 | 3 | 0 |
| Read | 0 | 1 | 1 | 3 | 0 | 0 | 3 | 3 | 0 | 0 |

In the write operation, a negative high voltage (e.g., -8 V) is applied to the word line WL₀₁, while the main bit line MBL₁ is put in the floating state, and a predetermined positive voltage (e.g., 4 V) is applied to the main bit line MBL₂. The selective line ST₂₁ is set at a low level (6 V) to turn on the selective transistor Q₁ and thus connect the sub-bit line SBL₁ to the main bit line MBL₁. Simultaneously, the selective lines ST₁₁ and ST₄₁ are set at a low level (e.g., 0 V) to turn off the selective transistors Q₂ and Q₅ and put the sub-bit lines SBL₃ and SBL₄ in the floating state. As a result, in the selected cell C₃₁, a negative high voltage is applied to the control gate 7, 0 V is applied to the source diffusion layer 2b, and a predetermined positive voltage is applied to the drain diffusion layer 2a. This causes a tunnel current to flow into the floating gate 5 (i.e., electrons are drawn out), and thus data to be written in the selected cell C₃₁.

At that time, the drain disturb immunity of the memory cells connected with the same sub-bit line SBL₁ can be improved by applying a voltage lower than the voltage applied to the drain to the non-selected word lines WL in the same block.

The erase operation is conducted for every sector or every block. The voltage of 0 V is applied to the main bit lines MBL₁, MBL₂, and MBL₃ and a positive high voltage (e.g., 17 V) is applied to a predetermined word line, e.g., the word line WL₀₁, while 0 V is applied to the other word lines WLₙ₁. Data of the memory cells connected with the word line WL to which the positive high voltage has been applied are erased, while data of the memory cells connected with the word lines WL to which 0 V is applied are not erased, by setting the selective lines ST₁₁, ST₂₁, ST₃₁, and ST₄₁ at a high level (e.g., 3 V) and turning all the selective transistors in the block where the memory cells to be erased are included. Accordingly, when sector-unit erasing is conducted, a positive high voltage is applied to only one word line, while 0 V is applied to the other word lines.

When block-unit erasing is conducted, data in all the memory cells in the block 410 are erased at one time by applying a high voltage to all the word lines in the block 410 simultaneously.

The read operation for the selected cell C₃₁ is conducted in the following manner. A predetermined positive voltage (e.g., 1 V) is applied to the main bit line MBL₂, while a positive voltage (e.g., 3 V) is applied to the word line WL₀₁.The selective lines ST₂₁ and ST₃₁ are set at a high level (e.g., 3 V) to turn on the selective transistors Q₁ and Q₄. No "soft write" phenomenon occurs in the memory cells by reading data from the low-density source diffusion layer side.

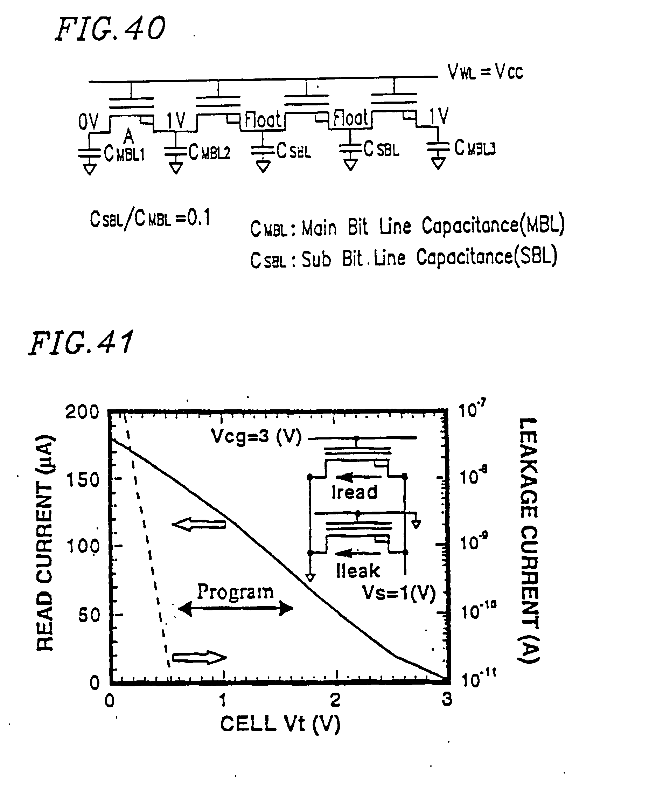

At this time, the selective transistor Q₃ is turned on simultaneously, allowing the sub-bit line SBL₅ to be connected to the main bit line MBL₃. Figure 40 shows how the memory cells connect with the word line WL₀₁. Referring to Figure 40, in the read operation for a selected memory cell (A in Figure 40), when a positive voltage is applied to the word line WL₀₁, the drain diffusion layer (sub-bit line SBL₁) is connected to the main bit line MBL₁ (ground level) via the selective transistor Q₁, the source diffusion layer (sub-bit line SBL₂) is connected to the main bit line MBL₂ (1 V) via the selective transistor Q₄, and the sub-bit line SBL₅ is connected to the main bit line MBL₃ via the selective transistor Q₃. At this time, the memory cell transistor is turned on or off depending on whether data stored in the memory cell C₃₁ is 1 or 0. When the memory cell transistor is off, correct reading of data may not be possible due to the lowering of the potential at the main bit line MBL₂ (sub-bit line SBL₂). To avoid this occurrence, the same potential is applied to the main bit line MBL₃ (sub-bit line SBL₅). The sub-bit lines SBL₃ and SBL₄ are in the floating state and the parasitic capacitance in the sub-bit lines is small compared with the main bit lines. The influence of the sub-bit lines is therefore small. When the memory cell transistor is on, the leakage current flowing from the memory cell C₃₂ through the memory cell C₃₄ is negligible compared with the current flowing to the memory cell C₃₁, even if the same voltage has been applied to the main bit line MBL₃ (sub-bit line SBL₅), causing no trouble for reading.

In Figure 40, the capacitance of the main bit line is denoted as C_{MRL}.

When data is read from the memory cell A connected with the word line WL₀₁, the leakage current flowing along the word line WLₙ₁ from the sub-bit line SBL₂ to the sub-bit line SBL₁ adjacent each other in the Y direction is negligible compared with the channel current of the memory cell A in which the data has been written, as shown in Figure 41. As is observed from Figure 41, when the threshold voltage of the memory cell is more than 0.5 V, the leakage Current of the non-selected memory cell of which control gate is grounded is smaller than the read current by seven digits, which is therefore negligible.

Now, an alternative example of the driving method of the nonvolatile semiconductor memory 400 will be described. In the above driving method, a high voltage (17 V) is applied to the word line in the erase operation. However, the high voltage applied to the word line can be reduced by applying a negative voltage to the diffusion layer 2 and the semiconductor substrate 1 in the erase operation.

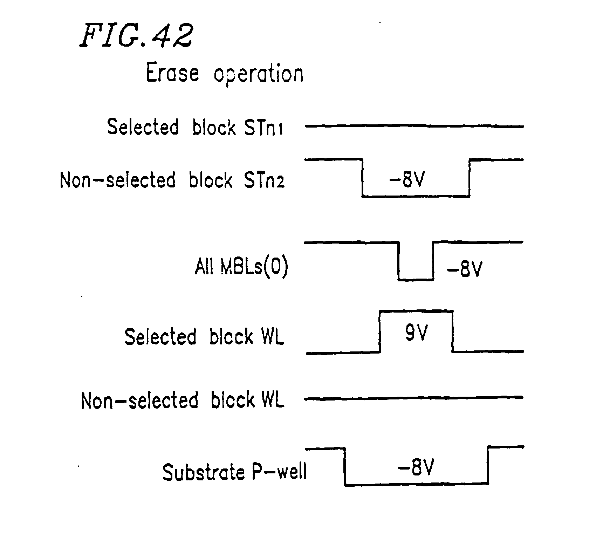

According to this alternative driving method, in the erase operation, the selective transistors in a non-selected block are turned off, to put the diffusion layers 2 (i.e., the sub-bit lines SBL) of the non-selected block in the floating state. When a negative voltage is applied to the semiconductor substrate 1, the selective transistors Q are turned on or off depending on the high level (0 V) or the low level (negative voltage, e.g., -8 V) of the selective lines. Specifically, as shown in Figures 39 and 42, the selective lines STₙ₁ (n=1 to 4) of the selected block 410 are set at 0 V and the selective lines STₙ₂ (n=1 to 4) of the non-selected block 410' are set at a low level (-8 V).

As shown in Figure 42, a negative voltage (e.g., -8 V) is applied to the semiconductor substrate 1, while a positive voltage (e.g., 9 V) is applied to the word lines WL (i.e., the control gates 7) and a negative voltage (e.g., -8 V) is applied to the diffusion layers 2 (main bit lines MBL) in the selected block 410. As a result, all data in the selected block 410 are erased.

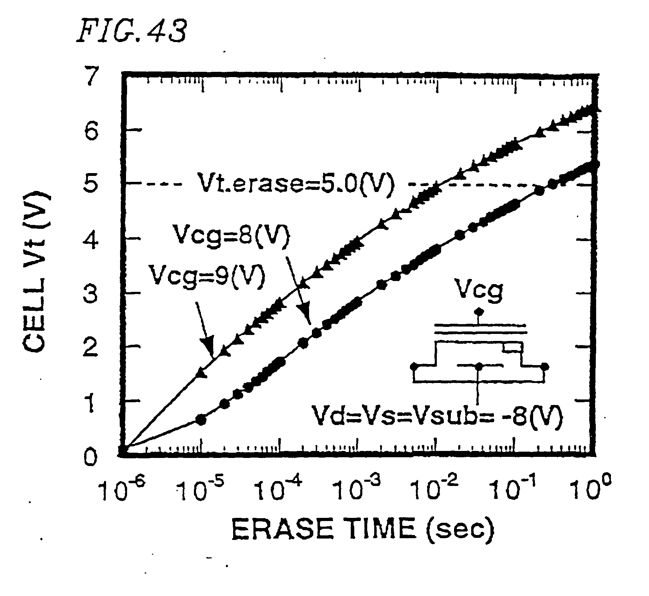

Figure 43 shows the time required to erase data in a memory cell (erase time) when voltages of 8 V and 9 V are applied to the control gate 7. As is observed from Figure 43, assuming that the threshold voltage of the memory cell in the erase state is 5 V, when a voltage of 9 V is applied to the control gate 7, data in the memory cell is erased in about 10⁻² seconds.

The memory cell array is formed on a well which is formed in the semiconductor substrate. When a negative voltage is applied to the well, it is necessary to isolate the well for each block to prevent the negative voltage from being applied to other non-selected blocks formed on the same substrate. Isolating the well for every block results in increasing the size of the memory. In practice, however, no problem will occur in the aspect of reliability of the memory cells if the well is not isolated for every block, due to the following reasons.

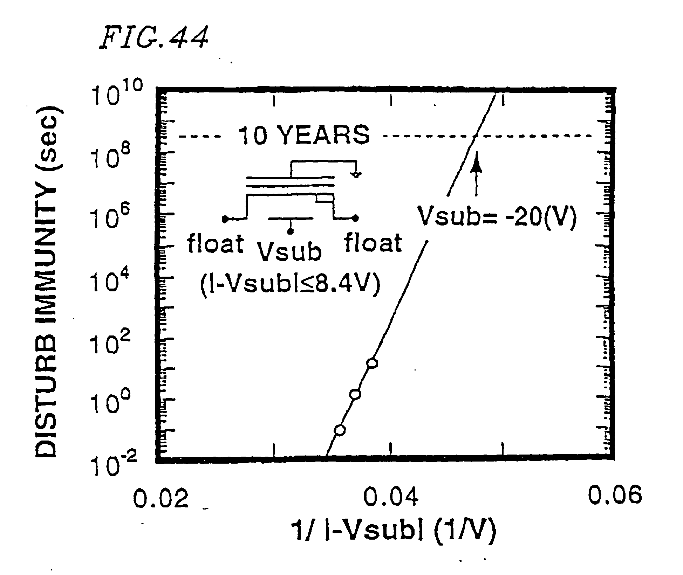

Figure 44 shows the relationship between the negative voltage (-V_{sub}) applied to the semiconductor substrate and the reliability (disturb immunity) of the tunnel insulating film (thickness: about 80 Å). As is observed from Figure 44, when the tunnel insulating film with a thickness of about 80 Å is formed, the nonvolatile semiconductor memory has a life of 10 years or longer as long as the voltage applied to the substrate does not exceed -20 V.

Another example of the write operation will be described. In writing data in each memory cell, as described above, only the selective transistors connected with the selected block 410 are turned on. Then, while a negative voltage (e.g., -8V) is applied to the word line WL (i.e., the control gate 7) connected with the selected cell in which data is to be written, a voltage corresponding to the data is applied to the sub-bit line SBL connected with the drain diffusion layer 2a of the selected cell.

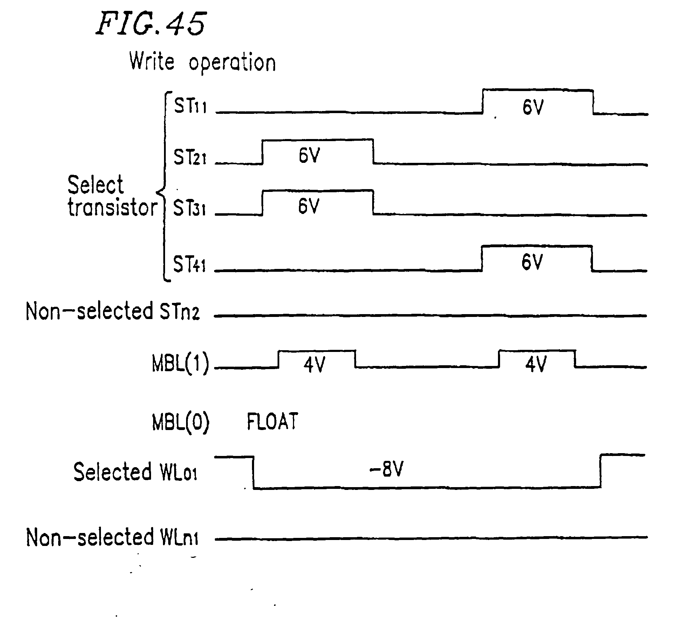

In this example, two sub-bit lines SBL are connected to one main bit line MBL via respective selective transistors. In the nonvolatile semiconductor memory 400, the main bit line MBL is selected in the following manner so that data can be written in the corresponding memory cell. Hereinbelow, the case where the main bit line MBL₂ is selected as the drain wiring will be described with reference to Table 4 below and Figure 45.

**TABLE 4**

| Operation mode | Main bit line voltage (V) | | | Word line voltage (V) | | Selective line voltage (V) | | | | |
|---|---|---|---|---|---|---|---|---|---|---|
| | | | | Selected | Non-selected | Selected | | | | Non-selected |
| | MBL1 | MBL2 | MBL3 | WLₒ₁ | WLₙ₁ | ST₁₁ | ST₂₁ | ST₃₁ | ST₄₁ | STᵢₙ |
| Write | 4/Float | 4/float | 4/Float | -8 | 0 | 0 | 6 | 6 | 0 | 0 |
| | 4/Float | 4/Float | 4/Float | -8 | 0 | 6 | 0 | 0 | 6 | 0 |

Referring to Table 4 and Figure 45, a negative write voltage (-8 V) is applied to the selected word line WL₀₁. The ground voltage (0 V) is retained for the non-selected word lines WLₙ₁ (n≠O). Then, the selective lines ST₂₁ and ST₃₁ are set at a high level (6 V), the sub-bit line SBL₁ is connected to the main bit line MBL₁ via the selective transistor Q₁, the sub-bit line SBL₂ is connected to the main bit line MBL₂ via the selective transistor Q₄, and the sub-bit line SBL₃ is connected to the main bit line MBL₃ via the selective transistor Q₃. Under this state, a write voltage is applied to the main bit line MBL depending on the data to be stored in the memory cell C in which the data is to be written. For example, 4 V is applied as the write voltage for data 1 to allow a tunnel current to flow, while the floating state is established for data 0 to inhibit writing. Thus, data are written in the memory cells C₃₁, C₃₂, C₃₅, (not shown), etc. The selective lines for the other non-selected selective transistors are retained grounded.

While the negative write voltage (-8 V) is kept applied to the selective word line WL₀₁, the selective lines ST₂₁ and ST₃₁ are set at a low level (0 V), and then the selective lines ST₁₁ and ST₄₁ are set at a high level (5 V). The sub-bit line SBL₃ is connected to the main bit line MBL₁ via the selective transistor Q₂, and the sub-bit line SBL₄ is connected to the main bit line MBL₂ via the selective transistor Q₅. Likewise, a write voltage corresponding to the memory cell C to be selected next is applied to each main bit line MBL (4 V for data 1, while the floating state is established for data 0). Thus, data are written in the memory cells C₃₃ and C₃₄. By these two write operations, writing to the memory cells connected with the word line WL₀₁ is completed. After the writing, the potential at the word line WL₀₁ is returned to the ground voltage (0 V).

In this example, two sub-bit lines SBL are connected to one main bit line MBL. However, an arbitrary number (N) of sub-bit lines SBL may be connected to the main bit line MBL via corresponding selective transistors. In this case, when one word line WL is selected, data can be written in all memory cells corresponding to the N sub-bit lines SBL connected to one main bit line MBL by N-time repetition of the write operation.

Figure 46 shows an alternative example of a nonvolatile semiconductor memory 430 where only one sub-bit line SBL is connected to each main bit line MBL via the corresponding transistor Q (N=1). Referring to Figure 46, the sub-bit line SBL₁, for example, is connected to the main bit line MBL₁ via the selective transistor Q₁. The sub-bit lines SBL₁, SBL₂, ... are electrically isolated from the main bit lines MBL₁, MBL₂, ... and put in the floating state by turning off the selective transistors Q₁, Q₂, ...,respectively.

In the nonvolatile semiconductor memory 430, data can be written in all the memory cells connected with one word line by one write operation. However, the main bit line is required for every sub-bit line. Since the memory cell size is determined by the pitch of the metal wirings, this configuration of the nonvolatile semiconductor memory 430 is not suitable for miniaturization compared with the device shown in Figure 39.

Thus, a tunnel current flows only between the drain diffusion layer and the floating gate by applying a predetermined voltage to the source/drain diffusion layer (bit line). This allows the flash memory to conduct the write operation using an FN tunnel current while employing the virtual ground method. Thus, the size of the flash memory can be made smaller.

The impurity density is made different between the source diffusion layer and the drain diffusion layer constituting the source/drain diffusion layer which is shared by two adjacent memory cells. This makes it possible to flow a tunnel current only in the region of the memory cell coupled with the drain diffusion layer.

The thicker portion (the gate insulating film) and the thinner portion (the tunnel insulating film) are formed in the insulating film formed underneath the floating gate. This makes it possible to flow a tunnel current only on the drain side of the memory cell capacitively coupled via the tunnel insulating film when a predetermined voltage is applied, even though the memory cell shares the source/drain diffusion layer with an adjacent memory cell.

All the comparatively thin tunnel insulating films are formed above the source/drain diffusion layers. This makes it possible to greatly reduce the generation of an interband tunnel current in the write operation and thus improve the write efficiency and the reliability of the memory cells.

The nitride film spacers are formed as the mask defining the arrangement of the source/drain diffusion layers, and the tunnel regions are defined by use of the nitride film spacers. Thus, the tunnel regions can be made smaller. This makes it possible to increase the capacitance coupling ratio of the control gates, eliminating the necessity of a high voltage transistor module, and thus reducing processing costs.

The wiring portions of the source/drain diffusion layers, i.e., the portions of the diffusion layers other than the source coupling regions and the drain coupling regions coupled with the floating gates (tunnel regions) are covered with the comparatively thick insulating films. This makes it possible to reduce the parasitic capacitance between the control gates and the bit lines.

Various other modifications will be apparent to and can be readily made by those skilled in the art without departing from the scope and spirit of this invention. Accordingly, it is not intended that the scope of the claims appended hereto be limited to the description as set forth herein.

## Claims

1. A nonvolatile semiconductor memory (100) comprising:
a semiconductor substrate (1);
a plurality of memory cells (C) formed in a matrix on the semiconductor substrate, each of the memory cells including a first insulating film (3) formed on the semiconductor substrate, a floating gate (5) formed on the first insulating film (3), and a control gate (7) formed on the floating gate (5) via a second insulating film (6) sandwiched therebetween, a source diffusion region, and a drain diffusion region;
a diffusion layer (2) formed in a portion of the semiconductor substrate (1) located between two of the memory cells (C) adjacent in a first direction, the diffusion layer (2) including the drain diffusion region for one of the two memory cells (C) and the source diffusion region for the other memory cell;
a word line formed by connecting the control gates (7) of the memory cells (C) lined in the first direction; and
a bit line formed by connecting the diffusion layers lined in a second direction substantially perpendicular to the first direction,
wherein the memory cells have a structure in which a tunnel current flows between the drain diffusion region and the floating gate (5) of one of the two adjacent memory cells via the first insulating film when a predetermined voltage is applied to the diffusion layer and no tunnel current flows between the diffusion layer and the floating gate of the other memory cell,
wherein the impurity dose amount of the source diffusion layer is set in proportion with the drain diffusion layer, such that the impurity dose amount of the source diffusion layer is less than the impurity dose amount of the drain diffusion layer by a factor of 100 times or more.

2. A nonvolatile semiconductor memory (100) according to claim 1,
wherein the impurity dose amount of the drain diffusion layer is set to be 5 x 10¹⁵ /cm², while the impurity dose amount of the source diffusion layer is set to be 5 x 10¹³ /cm² or less.

3. A nonvolatile semiconductor memory (100) according to claim 2,
wherein the drain diffusion region has a double-layered diffusion layer structure where the impurity dose amount or impurity density is lower in an outer layer.

4. A nonvolatile semiconductor memory (100) according to claim 1, operable to conduct writing and erasing using a tunnel current,
wherein the plurality of memory cells (C) formed in the matrix on the semiconductor substrate (1) are divided into a plurality of blocks,
wherein the bit line includes:
a first bit line formed by connecting diffusion layers formed between the memory cells adjacent in the first direction in a second direction perpendicular to the first direction; and
a second bit line provided to correspond to a predetermined number of the first bit lines,
wherein the memory further comprises a selective transistor provided to correspond to each of the first bit lines for connecting the first bit line to the corresponding second bit line, wherein the selective transistor electrically connects the first bit lines in a selected block to the corresponding second bit lines and puts the first bit lines in blocks other than the selected block in a floating state, in order to conduct an erase operation for every block.

5. A nonvolatile semiconductor memory (100) according to claim 4,
wherein the plurality of blocks are formed within one well region of the semiconductor substrate (1).

6. A method for erasing data stored in a nonvolatile semiconductor memory (100) as claimed in claim 4,
the method comprising the steps of:
electrically connecting the first bit lines in a selected block to the corresponding second bit lines, while putting the first bit lines in blocks other than the selected block in a floating state by controlling the selective transistors;
applying a predetermined negative voltage to the first bit lines and the semiconductor substrate;
applying a predetermined positive voltage to the word lines in the selected block, while applying a ground voltage to the word lines in the blocks other than the selected block; and
consequently erasing data in the memory cells in the selected block using a tunnel current.

7. A method for reading data stored in a nonvolatile semiconductor memory (100) as claimed in claim 4,
the method comprising the steps of:
applying a predetermined voltage to the word line connected with the memory cell from which data is to be read;
applying a predetermined voltage to one of the first bit lines connected with a source diffusion layer of the memory cell from which data is to be read, and applying the same predetermined voltage to the other first bit lines existing in parallel with the one of the first bit lines via the one of the first bit lines under a floating state.

8. A method for fabricating a nonvolatile semiconductor memory (100), comprising the steps of:
forming a first insulating film (3) on a semiconductor substrate (1) of a first conductivity type;
forming a first nitride film having a first width on the first insulating film by patterning;
covering the first nitride film with an oxide film and then forming spacers on both side walls of the first nitride film, the spacer on one of the side walls corresponding to a region defining a tunnel region;
forming a diffusion layer by implanting impurities of a second conductivity type using the first nitride film and the spacers on the side walls as a mask;
removing the spacer on the other side wall of the first nitride film;
forming a second insulating film having a thickness larger than that of the first insulating film selectively using the first nitride film and the spacer as a mask;
removing the spacer on the one of the both side walls of the first nitride film and a portion of the first insulating film located below the spacer;
forming a thermal oxide film in a region where the spacer on the other side wall and the portion of the first insulating film have been removed;
removing the first nitride film;
removing the thermal oxide film;
forming a tunnel region by forming a tunnel insulating film on a region where the thermal oxide film has been removed; and
forming a floating gate to cover the tunnel region,
wherein a plurality of memory cells (C) formed in a matrix on the substrate, each of the memory cells including the floating gate that covers the tunnel region,
wherein the diffusion layer includes a drain diffusion region for one of two adjacent memory cells (C) and a source diffusion region for the other of two adjacent memory cells (C),
wherein a structure is formed in the memory cells such that a tunnel current flows between the drain diffusion region and the floating gate (5) of one of the two adjacent memory cells via the first insulating film when a predetermined voltage is applied to the diffusion layer and no tunnel current flows between the diffusion layer and the floating gate of the other memory cell, and
wherein the impurity dose amount of the source diffusion region is set in proportion with the drain diffusion region, such that the impurity dose amount of the source diffusion region is less than the impurity dose amount of the drain diffusion region by a factor of 100 times or more.

9. A method according to claim 8, wherein the impurity dose amount of the drain diffusion region is set to be 5 x 10¹⁵ /cm², while the impurity dose amount of the source diffusion region is set to be 5 x 10¹³ /cm² or less.

## Patentansprüche

1. Nichtflüchtiger Halbleiterspeicher (100), mit:
einem Halbleitersubstrat (1);
mehreren Speicherzellen (C), die in einer Matrix auf dem Halbleitersubstrat gebildet sind, wobei jede der Speicherzellen eine erste Isolierschicht (3), die auf dem Halbleitersubstrat gebildet ist, ein schwebendes Gate (5), das auf der ersten Isolierschicht (3) gebildet ist, ein Steuergate (7), das auf dem schwebenden Gate (5) über eine dazwischen eingebettete zweite Isolierschicht (6) gebildet ist, einen Source-Diffusionsbereich und einen Drain-Diffusionsbereich enthält;
einer Diffusionslage (2), die in einem Abschnitt des Halbleitersubstrats (1), der sich zwischen zwei der Speicherzellen (C) befindet, die in einer ersten Richtung benachbart sind, ausgebildet ist, wobei die Diffusionsschicht (2) den Drain-Diffusionsbereich für eine der beiden Speicherzellen (C) und den Source-Diffusionsbereich für die andere Speicherzelle enthält;
einer Wortleitung, die durch Verbinden der Steuergates (7) der in der ersten Richtung angeordneten Speicherzellen (C) gebildet ist; und
einer Bitleitung, die durch Verbinden der Diffusionslagen, die in einer zu der ersten Richtung im Wesentlichen senkrechten zweiten Richtung angeordnet sind, gebildet ist,
wobei die Speicherzellen eine Struktur haben, in der zwischen dem Drain-Diffusionsbereich und dem schwebenden Gate (5) einer der beiden benachbarten Speicherzellen durch die erste Isolierschicht ein Tunnelstrom fließt, wenn eine vorgegebene Spannung an die Diffusionsschicht angelegt wird und zwischen der Diffusionsschicht und dem schwebenden Gate der anderen Speicherzelle kein Tunnelstrom fließt,
wobei der Störstellendosisbetrag der Source-Diffusionslage im Verhältnis zu der Drain-Diffusionslage festgelegt ist, so dass der Störstellendosisbetrag der Source-Diffusionslage um einen Faktor 100 oder mehr kleiner ist als der Störstellendosisbetrag der Drain-Diffusionslage.

2. Nichtflüchtiger Halbleiterspeicher (100) nach Anspruch 1, wobei der Störstellendosisbetrag der Drain-Diffusionslage auf 5 × 10¹⁵/cm² gesetzt ist, während der Störstellendosisbetrag der Source-Diffusionslage auf 5 x 10¹³/cm² oder weniger gesetzt ist.

3. Nichtflüchtiger Halbleiterspeicher (100) nach Anspruch 2, wobei der Drain-Diffusionsbereich eine Doppellagen-Diffusionslagenstruktur besitzt,
wobei der Störstellendosisbetrag oder die Störstellendichte in einer äußeren Lage niedriger ist.

4. Nichtflüchtiger Halbleiterspeicher (100) nach Anspruch 1, der betreibbar ist, um ein Schreiben und ein Löschen unter Verwendung eines Tunnelstroms auszuführen,
wobei die mehreren Speicherzellen (C), die in der Matrix auf dem Halbleitersubstrat (1) gebildet sind, in mehrere Blöcke unterteilt sind,
wobei die Bitleitung enthält:
eine erste Bitleitung, die durch Verbinden von Diffusionslagen, die zwischen den in der ersten Richtung benachbarten Speicherzellen gebildet sind, in einer zu der ersten Richtung senkrechten zweiten Richtung gebildet ist; und
eine zweite Bitleitung, die so vorgesehen ist, dass sie einer vorgegebenen Anzahl der ersten Bitleitungen entspricht,
wobei der Speicher ferner einen selektiven Transistor aufweist, der so vorgesehen ist, dass er jeder der ersten Bitleitungen entspricht, um die erste Bitleitung mit der entsprechenden zweiten Bitleitung zu verbinden, wobei der selektive Transistor die ersten Bitleitungen in einem ausgewählten Block mit den entsprechenden zweiten Bitleitungen verbindet und die ersten Bitleitungen in Blöcken, die von dem ausgewählten Block verschieden sind, in einen schwebenden Zustand versetzt, um eine Löschoperation für jeden Block auszuführen.

5. Nichtflüchtiger Halbleiterspeicher (100) nach Anspruch 4, wobei die mehreren Blöcke in einem Wannenbereich des Halbleitersubstrats (1) gebildet sind.

6. Verfahren zum Löschen von Daten, die in einem nichtflüchtigen Halbleiterspeicher (100) nach Anspruch 4 gespeichert sind,
wobei das Verfahren die folgenden Schritte enthält:
elektrisches Verbinden der ersten Bitleitungen in einem ausgewählten Block mit den entsprechenden zweiten Bitleitungen, wobei die ersten Bitleitungen in Blöcken, die von dem ausgewählten Block verschieden sind, durch Steuern der selektiven Transistoren in einen schwebenden Zustand versetzt werden;
Anlegen einer vorgegebenen negativen Spannung an die ersten Bitleitungen und an das Halbleitersubstrat;
Anlegen einer vorgegebenen positiven Spannung an die Wortleitungen in dem ausgewählten Block, während an die Wortleitungen in den von dem ausgewählten Block verschiedenen Blöcken eine Massespannung angelegt wird; und
anschließendes Löschen von Daten in den Speicherzellen in dem ausgewählten Block unter Verwendung eines Tunnelstroms.

7. Verfahren zum Lesen von Daten, die in einem nichtflüchtigen Halbleiterspeicher (4) nach Anspruch 4 gespeichert sind,
wobei das Verfahren die folgenden Schritte enthält:
Anlegen einer vorgegebenen Spannung an die Wortleitung, die mit der Speicherzelle verbunden ist, aus der Daten gelesen werden sollen;
Anlegen einer vorgegebenen Spannung an eine der ersten Bitleitungen, die mit einer Source-Diffusionslage der Speicherzelle verbunden ist, aus der Daten gelesen werden sollen, und Anlegen derselben vorgegebenen Spannung an die anderen ersten Bitleitungen, die parallel zu der einen der ersten Bitleitungen vorhanden sind, über die eine der ersten Bitleitungen in schwebendem Zustand.

8. Verfahren zum Herstellen eines nichtflüchtigen Halbleiterspeichers (100), das die folgenden Schritte enthält:
Bilden einer ersten Isolierschicht (3) auf einem Halbleitersubstrat (1) eines ersten Leitfähigkeitstyps;
Bilden einer ersten Nitridschicht, die eine erste Breite besitzt, auf der ersten Isolierschicht durch Musterbildung;
Abdecken der ersten Nitridschicht mit einer Oxidschicht und dann Bilden von Abstandhaltern an beiden Seitenwänden der ersten Nitridschicht, wobei die Abstandhalter an einer der Seitenwände einem einen Tunnelbereich definierenden Bereich entsprechen;
Bilden einer Diffusionslage durch Implantieren von Störstellen eines zweiten Leitfähigkeitstyps unter Verwendung der ersten Nitridschicht und der Abstandhalter an den Seitenwänden als eine Maske;
Entfernen der Abstandhalter an der anderen Seitenwand der ersten Nitridschicht;
Bilden einer zweiten Isolierschicht, die eine Dicke besitzt, die größer als jene der ersten Isolierschicht ist, wobei wahlweise die erste Nitridschicht und der Abstandhalter als Maske verwendet werden;
Entfernen des Abstandhalters an der einen der beiden Seitenwände der ersten Nitridschicht und eines Teils der ersten Isolierschicht, die sich unter dem Abstandhalter befindet;
Bilden einer thermischen Oxidschicht in einem Bereich, in dem der Abstandhalter an der anderen Seitenwand und der Teil der ersten Isolierschicht entfernt worden sind;
Entfernen der ersten Nitridschicht;
Entfernen der thermischen Oxidschicht;
Bilden eines Tunnelbereichs durch Bilden einer Tunnelisolierschicht auf einem Bereich, in dem die thermische Oxidschicht entfernt worden ist; und
Bilden eines schwebenden Gates, um den Tunnelbereich abzudecken,
wobei mehrere Speicherzellen (C) in einer Matrix auf dem Substrat gebildet sind, wobei jede der Speicherzellen das schwebende Gate enthält, das den Tunnelbereich abdeckt,
wobei die Diffusionslage einen Drain-Diffusionsbereich für eine der zwei benachbarten Speicherzellen (C) und einen Source-Diffusionsbereich für die andere der zwei benachbarten Speicherzellen (C) enthält,
wobei in den Speicherzellen eine Struktur gebildet wird, derart, dass zwischen dem Drain-Diffusionsbereich und dem schwebenden Gate (5) einer der zwei benachbarten Speicherzellen durch die erste Isolierschicht ein Tunnelstrom fließt, wenn an die Diffusionslage eine vorgegebene Spannung angelegt wird und zwischen der Diffusionslage und dem schwebenden Gate der anderen Speicherzelle kein Tunnelstrom fließt, und
wobei der Störstellendosisbetrag des Source-Diffusionsbereichs im Verhältnis zum Drain-Diffusionsbereich festgelegt wird, so dass der Störstellenbetrag des Source-Diffusionsbereichs um einen Faktor 100 oder mehr kleiner ist als der Störstellendosisbetrag des Drain-Diffusionsbereichs.

9. Verfahren nach Anspruch 8, wobei der Störstellendosisbetrag des Drain-Diffusionsbereichs auf 5 × 10¹⁵/cm² gesetzt ist, während der Störstellendosisbetrag des Source-Diffusionsbereichs auf 5 × 10¹³/cm² oder weniger gesetzt ist.

## Revendications

1. Mémoire non volatile à semi-conducteur (100) comprenant :
un substrat semi-conducteur (1) ;
plusieurs cellules de mémoire (C) formées dans une matrice sur le substrat semi-conducteur, chacune des cellules de mémoire comprenant un premier film isolant (3) formé sur le substrat semi-conducteur, une grille flottante (5) formée sur le premier film isolant (3), et une grille de commande (7) formée sur la grille flottante (5), avec un second film isolant (6) placé en sandwich entre les deux, une zone de diffusion de source et une zone de diffusion de drain ;
une couche de diffusion (2) formée dans une partie du substrat semi-conducteur (1) située entre deux des cellules de mémoire (C) voisines dans une première direction, la couche de diffusion (2) comprenant la zone de diffusion de drain pour l'une des deux cellules de mémoire (C) et la zone de diffusion de source pour l'autre cellule de mémoire ;
une ligne de mot formée grâce à la liaison des grilles de commande (7) des cellules de mémoire (C) alignées dans la première direction ; et
une ligne de binaire formée grâce à la liaison des couches de diffusion alignées dans une seconde direction globalement perpendiculaire à la première,
les cellules de mémoire ayant une structure dans laquelle un courant de tunnel passe entre la zone de diffusion de drain et la grille flottante (5) de l'une des deux cellules de mémoire voisines, par l'intermédiaire du premier film isolant, quand une tension prédéterminée est appliquée à la couche de diffusion, et aucun courant de tunnel ne passe entre la couche de diffusion et la grille flottante de l'autre cellule de mémoire,
la dose d'impuretés de la couche de diffusion de source étant calculée par rapport à la couche de diffusion de drain de telle sorte qu'elle soit inférieure à la dose d'impuretés de celle-ci d'un facteur de 100 fois ou plus.

2. Mémoire non volatile à semi-conducteur (100) selon la revendication 1, dans laquelle la dose d'impuretés de la couche de diffusion de drain est calculée pour être égale à 5×10¹⁵/cm² tandis que la dose d'impuretés de la couche de diffusion de source est calculée pour être égale à 5×10¹³/cm² ou moins.

3. Mémoire non volatile à semi-conducteur (100) selon la revendication 2, dans laquelle la zone de diffusion de drain a une structure à double couche de diffusion dans les cas où la dose d'impuretés ou la densité d'impuretés est inférieure dans une couche extérieure.

4. Mémoire non volatile à semi-conducteur (100) selon la revendication 1, apte à réaliser une écriture et un effacement à l'aide d'un courant de tunnel,
dans laquelle les cellules de mémoire (C) formées dans la matrice sur le substrat semi-conducteur (1) sont divisées en plusieurs blocs,
la ligne de binaire comprenant :
une première ligne de binaire formée grâce à la liaison de couches de diffusion, formées entre les cellules de mémoire voisines dans la première direction, dans une seconde direction perpendiculaire à la première direction ;
et une seconde ligne de binaire prévue pour correspondre à un nombre prédéterminé de premières lignes de binaire,
la mémoire comprenant par ailleurs un transistor sélectif prévu pour correspondre à chacune des premières lignes de binaire pour relier la première ligne de binaire à la seconde ligne de binaire correspondante, le transistor sélectif reliant électriquement les premières lignes de binaire d'un bloc sélectionné aux secondes lignes de binaire correspondantes, et mettant les premières lignes de binaire de blocs autres que le bloc sélectionné dans un état flottant, afin de procéder à une opération d'effacement pour chaque bloc.

5. Mémoire non volatile à semi-conducteur (100) selon la revendication 4, dans laquelle les blocs sont formés à l'intérieur d'une zone de caisson du substrat semi-conducteur (1).

6. Procédé pour effacer des données stockées dans une mémoire non volatile à semi-conducteur (100) selon la revendication 4, comprenant les étapes qui consistent :
à relier électriquement les premières lignes de binaire d'un bloc sélectionné aux secondes lignes de binaire correspondantes, tout en mettant les premières lignes de binaire de blocs autres que le bloc sélectionné dans un état flottant, en commandant les transistors sélectifs ;
à appliquer une tension négative prédéterminée aux premières lignes de binaire et au substrat semi-conducteur ;
à appliquer une tension positive prédéterminée aux lignes de mot dans le bloc sélectionné, tout en appliquant une tension de mise à la masse aux lignes de mot dans les blocs autres que le bloc sélectionné ;
et à effacer en conséquence des données dans les cellules de mémoire dans le bloc sélectionné, à l'aide d'un courant de tunnel.

7. Procédé pour lire des données stockées dans une mémoire non volatile à semi-conducteur (100) selon la revendication 4, comprenant les étapes qui consistent :
à appliquer une tension prédéterminée à la ligne de mot reliée à la cellule de mémoire à partir de laquelle les données doivent être lues ;
à appliquer une tension prédéterminée à l'une des premières lignes de binaire reliées à une couche de diffusion de source de la cellule de mémoire à partir de laquelle les données doivent être lues, et à appliquer la même tension prédéterminée aux autres premières lignes de binaire existantes, parallèlement à ladite première lignes de binaire par l'intermédiaire de celle-ci dans un état flottant.

8. Procédé pour fabriquer une mémoire non volatile à semi-conducteur (100), comprenant les étapes qui consistent :
à former un premier film isolant (3) sur un substrat semi-conducteur (1) d'un premier type de conductivité ;
à former un premier film de nitrure ayant une première largeur sur le premier film isolant, à l'aide d'une formation de motifs ;
à couvrir le premier film de nitrure avec un film d'oxyde, et à former ensuite des pièces d'écartement sur les deux parois latérales du premier film de nitrure, la pièce d'écartement placée sur l'une des parois latérales correspondant à une zone qui définit une zone de tunnel ;
à former une couche de diffusion en implantant des impuretés d'un second type de conductivité, en utilisant le premier film de nitrure et les pièces d'écartement des parois latérales comme masque ;
à enlever la pièce d'écartement sur l'autre paroi latérale du premier film de nitrure ;
à former un second film isolant d'une épaisseur supérieure à celle du premier film isolant, en utilisant sélectivement le premier film de nitrure et la pièce d'écartement comme masque ;
à enlever la pièce d'écartement sur l'une des deux parois latérales du premier film de nitrure et une partie du premier film isolant située sous ladite pièce d'écartement ;
à former un film d'oxyde thermique dans une zone où la pièce d'écartement placée sur l'autre paroi latérale et là partie du premier film isolant ont été enlevée
à enlever le premier film de nitrure ;
à enlever le film d'oxyde thermique ;
à former une zone de tunnel en formant un film isolant de tunnel sur une zone où le film d'oxyde thermique a été enlevé ;
et à former une grille flottante pour couvrir la zone de tunnel,
étant précisé que plusieurs cellules de mémoire (C) sont formées dans une matrice sur le substrat, chacune des cellules de mémoire comprenant la grille flottante qui couvre la zone de tunnel,
que la couche de diffusion comprend une zone de diffusion de drain pour l'une des deux cellules de mémoire (C) voisines et une zone de diffusion de source pour l'autre cellule de mémoire (C),
qu'une structure est formée dans les cellules de mémoire de telle sorte qu'un courant de tunnel passe entre la zone de diffusion de drain et la grille flottante (5) de l'une des deux cellules de mémoire voisines, par l'intermédiaire du premier film isolant, quand une tension prédéterminée est appliquée à la couche de diffusion, et qu'aucun courant de tunnel ne passe entre la couche de diffusion et la grille flottante de l'autre cellule de mémoire,
et que la dose d'impuretés de la couche de diffusion de source est calculée par rapport à la couche de diffusion de drain de telle sorte qu'elle soit inférieure à la dose d'impuretés de celle-ci d'un facteur de 100 fois ou plus.

9. Procédé selon la revendication 8, selon lequel la dose d'impuretés de la zone de diffusion de drain est calculée pour être égale à 5×10¹⁵/cm² tandis que la dose d'impuretés de la couche de diffusion de source est calculée pour être égale à 5×10¹³/cm² ou moins.
